# EUROPEAN PATENT APPLICATION

(11) **EP 4 060 897 A1**
(43) Date of publication of application: **21.09.2022**
(21) Application number: 20888134.2
(22) Date of filing: 31.10.2020
(51) Int. Cl.: H03K 17/969, H03M 11/26, H03M 11/00, H03M 11/20, G02B 6/00

(54) **LIGHTGUIDE PLATE OPTICAL SWITCH AND LIGHTGUIDE PLATE ARRAY OPTICAL SWITCH MODULE**

(30) Priority: 14.11.2019 CN 201911110323; 14.10.2020 CN 202011096927
(71) Applicant: Chen, Feng, Chengdu, Sichuan 610041 (CN)
(72) Inventor: Chen, Feng, Chengdu, Sichuan 610041 (CN)
(74) Representative: Ipside
(86) International application number: PCT/CN2020/125677
(87) International publication number: WO 2021/093621

(57) **Abstract**

A lightguide plate optical switch and lightguide plate array optical switch module, comprising optical transmitters, optical receivers, a circuit wafer, an optical switch, and a lightguide plate. Optical signals transmitted by the optical transmitters are connected to the optical receivers by means of the optical switch. When the optical switch is triggered, propagating light paths between the optical transmitters and the optical receivers are interrupted. The lightguide plate is divided into multiple optical areas. Optical signals in the multiple optical areas are separated from each other. In each optical area, multiple optical transmitters are respectively connected to light paths of a group of optical receivers or are respectively connected to a light path of one optical receiver. The optical transmitters are connected to an output port of a CPU, and the optical receivers are connected to an input port of the CPU. Provided is a thin-film optical switch that has a simple fabrication process and low production costs, specifically provided is an ultrathin thin-film optical switch that has a long service life and is widely applicable in PC keyboards, thin membrane keyboards, and thin notebook keyboards.

## Description

### Technical Field

The present invention relates to a film array optical switch and a key switch using the film array optical switch, specifically relating to a film array optical switch mounted in a keyboard as an input device of an electronic instrument.

### Background of the Invention

### The existing contact type film array switch circuit has the following problems:

The ultra-thin contact type film array switch circuit used in the existing keyboard consists of two circuit films with silver paste circuits and silver paste contacts and one separation film. The silver paste circuits and silver paste contacts of the two circuit films are screen-printed with silver paste on the films to form very thin silver paste circuits and silver paste contacts. There are through holes on the separation film, and the separation film is located between the two circuit films and is bonded with the two circuit films respectively. The two circuit films are composed of the upper circuit film and the lower circuit film. The silver paste contacts of the upper circuit film, the silver paste contacts of the lower circuit film, and the through holes on the separation film correspond to each other. During use, when the silver paste contacts of the upper circuit film contact with the silver paste contacts of the lower circuit film in the through holes on the separation film under the action of external force, the switch is on, and when the silver paste contacts of the upper circuit film are reset without external force, the switch is off. The silver paste contacts of the existing contact type film array switch circuit are easy to oxidize and wear and have a short service life.

No low-cost, ultra-thin, and durable non-contact type film optical switch has been put into industrial production due to the huge waste of contact type film array switch circuits all over the world.

### The use of light guide plate array optical switch has the following problems:

### 1. A large number of I/O interfaces for the controller chip (hereinafter referred to as the CPU) are required - the cost rises significantly

The existing 101-key keyboard has six rows, with a maximum of 20 keys in one row and a minimum of 16 keys in a row. If key conflicts are not considered, the CPU I/O interfaces include 20 output interfaces (O) and 6 input interfaces (I). To solve some key conflicts, a total of 30 CPU I/O interfaces are used (key conflicts: if several keys are pressed simultaneously, the CPU cannot identify the coordinates of several keys pressed simultaneously). The existing keyboard has more keys, such as a 50-key keyboard, an 83-key keyboard, a 101-key keyboard, and a 120-key keyboard. If the CPU assigns an output interface to each key and connects it to an LED (the optical switch of each key is provided with an LED light source), a large number of output interfaces are required, resulting in the complex electronic circuit on the PCB board (circuit board 3-1) and the huge CPU size, so the cost rises significantly;
2. 101 LEDs consume too much power:
   Taking the commonly used 101-key keyboard as an example, the power of 101 LEDs (the power of each LED is 0.06 W) is 6.06 W. The laptop keyboard with a backlight uses about 12 LEDs and the power is about 1 W. The power of the existing laptop is generally 55 W - 60 W, and there is a general problem that heat causes its performance to decline. If only the photoelectric keyboard increases the power by about 10%, it is difficult to promote;
3. Key conflict:
   The matrix circuit technology is used for the switch circuits of film array switch circuits of the existing keyboard. The I/O interfaces of the CPU are added to solve the problem of key conflicts. For example, for the commonly used key combination Ctrl+A, the switch of the Ctrl key and the switch of the A key are connected to two input interfaces of the CPU respectively;
4. The keys of the keyboard using the light guide plate transmit light unevenly, and it is difficult to adjust the brightness of the proximal keycap from the light source part 10-1 to be consistent with the brightness of the distal keycap from the light source part 10-1;
5. The optical switches are added to the light guide module and 101 light source parts 10-1 are added with the cost of RMB 0.03 per light source part 10-1, and the film array switch circuit printed with silver paste is not used with the cost of RMB 7 - 127 per film array switch circuit, so the cost of the keyboard is greatly reduced;
6. The film array switch circuit is installed on the metal support plate 2. The film array switch circuit has as many openings as the metal support plate 2, and the film array switch circuit has a complicated waterproof process and poor reliability.

### Summary of the Invention

The object of the present invention is to provide an array optical switch on a non-contact light guide plate with a simple manufacturing process and low production cost, specifically providing an array optical switch module with long service life and ultra-thin thickness; after the array optical switch module is sealed, the array optical switch module can be washed with water, and its service life can also be greatly improved.

This invention provides a light guide plate optical switch and light guide plate array optical switch module, comprising an optical transmitter, an optical receiver, a circuit board, an optical switch, a CPU, and a light guide plate, wherein the optical signal transmitted by the optical transmitter is connected to the optical path of the optical receiver through the optical switch, the propagation optical path between the optical transmitter and the optical receiver is on/off when the optical switch is triggered, and the CPU has an on/off interface and a detection interface;
wherein the light guide plate is divided into a plurality of optical zones, and the optical signals in the plurality of optical zones are separated from each other;
in each optical zone, multiple optical transmitters are connected to the optical paths of a group of optical receivers respectively or to the optical path of an optical receiver;
the optical transmitter is connected to the on/off interface, and the optical receiver is connected to the detection interface;
during use, the CPU continuously detects the signals of multiple detection interfaces;
when an optical switch in a certain optical zone is pressed, the CPU judges whether an optical switch in a certain optical zone is pressed by detecting the detection interface.

Comprising an optical transmitter, an optical receiver, a circuit board, an optical switch, and a light guide plate, wherein the optical signal transmitted by the optical transmitter is connected to the optical path of the optical receiver through the optical switch, and the propagation optical path between the optical transmitter and the optical receiver is on/off when the optical switch is triggered;
wherein the light guide plate is divided into a plurality of optical zones, and the optical signals in the plurality of optical zones are separated from each other;
in each optical zone, multiple optical transmitters are connected to the optical paths of a group of optical receivers respectively or to the optical path of an optical receiver;
the optical transmitter is connected to a CPU output interface, the optical receiver is connected to a CPU input interface, and the optical transmitter in each optical zone transmits optical signals that can be recognized by the CPU;
during use, when an optical switch in a certain optical zone is pressed, the CPU judges whether an optical switch in a certain optical zone is pressed by detecting the CPU input interface.

Further the light guide plate consists of a switch light guide plate 7; the optical transmitter and the CPU output interface are connected as follows: an optical transmitter in one optical zone is connected to an optical transmitter in another optical zone to form an OT group...the above connection process is repeated to form a plurality of OT groups, and the plurality of OT groups are connected to a plurality of CPU output interfaces respectively.

Further comprising an optical transmitter, an optical receiver, a circuit board, an optical switch, and a switch light guide plate, wherein the optical signal transmitted by the optical transmitter is connected to the optical path of the optical receiver through the optical switch, and the optical path between the optical transmitter and the optical receiver is on/off when the optical switch is triggered;
wherein the switch light guide plate 7 is divided into at least two optical zones, and the two optical zones are a 1 optical zone 7a and a 2 optical zone 7b, and the optical signal in the 1 optical zone 7a is separated from the optical signal in the 2 optical zone 7b;
the light transmitting windows of multiple optical transmitters in the 1 optical zone 7a are connected to multiple optical switches and the optical path of an optical receiver G1, and the light transmitting windows of multiple optical transmitters in the 2 optical zone 7b are connected to multiple optical switches and the optical path of an optical receiver G2;
one optical transmitter in the 1 optical zone 7a is connected to one optical transmitter in the 2 optical zone 7b to form a connected OT group, and a 1 OT group, a 2 OT group, a 3 OT group... a n OT group are connected to a 1CPU output interface, a 2CPU output interface, a 3CPU output interface... a nCPU output interface respectively;
the optical receiver G1 and the optical receiver G2 are connected to a 1CPU input interface and a 2CPU input interface of the CPU respectively;
during use, the CPU continuously detects the signals of the 1CPU input interface and the 2CPU input interface;
when an optical switch in the 1 optical zone 7a is pressed, the CPU determines the change of the optical signal in the 1 optical zone 7a by detecting the 1CPU input interface, and the CPU judges whether an optical switch in the 1 optical zone 7a is pressed based on the change of the optical signal;
when an optical switch in the 2 optical zone 7b is pressed, the CPU determines the change of the optical signal in the 2 optical zone 7b by detecting the 2CPU input interface, and the CPU judges whether an optical switch in the 2 optical zone 7b is pressed based on the change of the optical signal.

Further the light guide plate array optical switch module further comprises a CPU wherein the CPU has a plurality of output interfaces and a plurality of input interfaces, the connected OT group is connected to the output interface through the CPU output interface, and the optical receiver is connected to the input interface through the CPU input interface;

The CPU output interface and the CPU input interface are located on the same circuit board as the output interface and the input interface, or the CPU output interface and the CPU input interface are located on different circuit boards from the output interface and the input interface.

Further the CPU continuously scans and detects each CPU input interface circularly or continuously detects each CPU input interface simultaneously, and when the CPU detects the signal change of an output interface, the CPU judges whether an optical switch is triggered based on the optical zone where an OT group connected to the CPU output interface and the optical transmitter connected to the OT group are located.

Further when the array optical switch module works, the CPU is connected to a CPU output interface, and an OT group connected to the CPU output interface has at most only one optical transmitter in each optical zone to transmit the optical signals; one group of optical receivers in each optical zone receive the optical signals or one optical receiver receives the optical signals, each CPU input interface connected to the OT group has signal input, CPU judges whether an optical switch in each optical zone is triggered, and the CPU closes the CPU output interface;
the CPU is connected to another CPU output interface, and an OT group connected to the CPU output interface has at most only one optical transmitter in each optical zone to transmit the optical signals; one group of optical receivers in each optical zone receive the optical signals or one optical receiver receives the optical signals, each CPU input interface connected to the OT group has signal input, CPU judges whether an optical switch in each optical zone is triggered, and the CPU closes the CPU output interface;
the above process is repeated continuously;
when an optical switch is triggered, the optical path in the optical zone is blocked, so that the optical receiver in the optical zone cannot receive the optical signal, no signal input is available from the CPU input interface connected to the optical receiver, and the CPU judges the position of the optical switch based on the connected OT group and the corresponding relationship between the optical zone and the optical receiver.

Further the CPU output interfaces of the CPU transmit different feature signals, and the optical transmitters connected to the OT group transmit different feature signals in the same optical zone.

Comprising an optical transmitter, an optical receiver, a circuit board, an optical switch, and a light guide plate, wherein the optical signal transmitted by the optical transmitter is connected to the optical path of the optical receiver through the optical switch, and the optical path between the optical transmitter and the optical receiver is on/off when the optical switch is triggered;
wherein the light guide plate is divided into a plurality of optical zones, and the optical signals in the plurality of optical zones are separated from each other;
in each optical zone, multiple optical transmitters are connected to the optical paths of a group of optical receivers respectively or to the optical path of an optical receiver, and the optical receivers in each optical zone are connected to the signal input interfaces of the CPU respectively;
an optical transmitter in one optical zone is connected to an optical transmitter in another optical zone to form an OT group in which at most one optical transmitter in each optical zone is connected... the above connection process is repeated to form a plurality of OT groups;
the CPU has feature output interfaces transmitting multiple different feature signals, wherein each feature output interface is connected to a plurality of OT groups, the plurality of OT groups are connected to form an OT feature group, and each OT group forming the OT feature group transmits different feature signals;
multiple OT feature groups are connected to multiple optical input interfaces of the CPU respectively, and the on/off of each OT feature group is controlled by one optical input interface of the CPU;
during use, the CPU continuously detects the signals of the signal input interfaces.

Comprising an optical transmitter, an optical receiver, a circuit board, an optical switch, and a light guide plate, wherein the optical signal transmitted by the optical transmitter is connected to the optical path of the optical receiver through the optical switch, and the optical path between the optical transmitter and the optical receiver is on/off when the optical switch is triggered;
wherein the light guide plate is divided into n optical zones: a 1 optical zone 7a, a 2 optical zone 7b, a 3 optical zone 7c... n optical zone respectively, and the optical signals in the optical zones are separated from each other;
multiple optical transmitters in the 1 optical zone 7a are connected to the optical path of the optical receiver G1,
multiple optical transmitters in the 2 optical zone 7b are connected to the optical path of the optical receiver G2,
multiple optical transmitters in the 3 optical zone 7c are connected to the optical path of the optical receiver G3,
   ...;
one optical transmitter in the 1 optical zone 7a, one optical transmitter in the 2 optical zone 7b, one optical transmitter in the 3 optical zone 7c... are electrically connected to form an OT group, and the above connection process is repeated to form a 1 OT group, a 2 OT group, a 3 OT group...;
the CPU has feature output interfaces transmitting multiple different feature signals, wherein each feature output interface is connected to a plurality of OT groups, the plurality of OT groups are connected to form a LED feature group, and the optical transmitters of the LED feature group in the same optical zone transmit different feature signals;
multiple LED feature groups are connected to multiple output interfaces of the CPU respectively, the on/off of each LED feature group is controlled by one output interface of the CPU, and the output interface consists of an output interface B1, an output interface B2, an output interface B3...,
the1LED feature group is connected to the output interface B1 of the CPU, and the output interface B1 controls the on/off of the 1 LED feature group,
the2LED feature group is connected to the output interface B2 of the CPU, and the output interface B2 controls the on/off of the 2LED feature group,
the3LED feature group is connected to the output interface B3 of the CPU, and the output interface B3 controls the on/off of the 3LED feature group...,
the optical receiver G1 in the 1 optical zone 7a, the optical receiver G2 in the 2 optical zone 7b, the optical receiver G3 in the 3 optical zone 7c... are connected to the input interface C1 of the CPU, the input interface C2 of the CPU, the input interface C3, and the input interface C3 of the CPU... respectively;
during use, the CPU continuously detects the signals of the input interface C1, the input interface C2, the input interface C3...

Further the CPU has two feature output interfaces transmitting different feature signals: a feature output interface A1 and a feature output interface A2, and the feature output interface A1 is connected to a plurality of OT groups and the feature output interface A2 is connected to a plurality of OT groups;
two OT groups connected to the feature output interface A1 and the feature output interface A2 are connected to form a 1 OT feature group, and the 1 OT feature group is then connected to the output interface B1,
two OT groups connected to the feature output interface A1 and the feature output interface A2 are connected to form a 2 OT feature group, and the 2 OT feature group is then connected to the output interface B2,
two OT groups connected to the feature output interface A1 and the feature output interface A2 are connected to form a 3 OT feature group, and the 3 OT feature group is then connected to the output interface B3,...
two OT groups connected to the feature output interface A1 and the feature output interface A2 are connected to form a n OT feature group, and the n OT feature group is then connected to the output interface Bn;
the output interface B1, the output interface B2, the output interface B3..., and the output interface Bn control the on/off of the 1 OT feature group, the 2 OT feature group, the 3 OT feature group..., and the n OT feature group respectively.

Further the light guide plate array optical switch module further comprises a circuit board and the circuit board is provided with a CPU output interface, a CPU input interface, and a CPU feature output interface; the CPU output interface, the CPU input interface, and the CPU feature output interface are connected to the output interface of the CPU, the output interface of the CPU, and the feature output interface of the CPU respectively;
the CPU output interface, the CPU input interface, and the CPU feature output interface on one circuit board are connected to the output interface, the input interface, and the feature output interface on another circuit board respectively, or the CPU output interface, the CPU input interface, and the CPU feature output interface are correspondingly connected to the output interface, the input interface, and the feature output interface, and the CPU output interface, the CPU input interface, and the CPU feature output interface are located on the same circuit board as the output interface, the input interface, and the feature output interface.

Further the CPU has two feature output interfaces transmitting different feature signals: a feature output interface A1 and a feature output interface A2, wherein when the feature output interface A1 transmits 01 and the feature output interface A2 transmits 10, it should be ensured that two signals of 0 transmitted by the feature output interface A1 and 1 transmitted by the feature output interface A2 are synchronized in time and two signals of 1 transmitted by the feature output interface A1 and 0 transmitted by the feature output interface A2 are synchronized in time, to ensure that only one OT group can transmit light at every moment; or the CPU has three feature output interfaces transmitting different feature signals: a feature output interface A1, a feature output interface A2, and a feature output interface A3, wherein when the feature output interface A1 transmits 001, the feature output interface A2 transmits 100, and the feature output interface A3 transmits 010, it should be ensured that three signals of 0 transmitted by the feature output interface A1, 1 transmitted by the feature output interface A2, and 0 transmitted by the feature output interface A3 are synchronized in time, three signals of 0 transmitted by the feature output interface A1, 0 transmitted by the feature output interface A2, and 1 transmitted by the feature output interface A3 are synchronized in time, and three signals of 1 transmitted by the feature output interface A1, 0 transmitted by the feature output interface A2, and 0 transmitted by the feature output interface A3 are synchronized in time, to ensure that only one OT group can transmit light at every moment; or the CPU has four feature output interfaces transmitting different feature signals:...

Further when the number of optical transmitters in each optical zone is equal, the number of optical transmitters in each OT group is the same, or when the number of optical transmitters in each optical zone is not equal, the number of optical transmitters in some OT groups is different.

Comprising an optical transmitter, an optical receiver, a circuit board, a light guide plate, and an optical switch, wherein the optical signal transmitted by the optical transmitter is connected to the optical path of the optical receiver through the propagation optical path on the light guide plate and the optical switch, and the optical path between the optical transmitter and the optical receiver is on/off when the optical switch is triggered;
wherein the light guide plate consists of a switch light guide plate 7, and the switch light guide plate 7 is provided with the light guide plate through holes penetrating through its plate surface; the light guide plate through holes consist of a LED switch hole 7-9, a guide plate blocking hole 7-2, a left front optical path hole 7-10, and a right front optical path hole 7-11, wherein the optical transmitter is a side-lighted optical transmitter, the optical transmitter is located in the LED switch hole 7-9, and the left front optical path hole 7-10 and the right front optical path hole 7-11 penetrate through the plate surface of the switch light guide plate 7 to form a front optical circuit board 7-12 between the left front optical path hole 7-10 and the right front optical path hole 7-11;
one end of the front optical circuit board 7-12 is located on the side wall of the LED switch hole 7-9 and is connected to the optical path of the optical transmitter and the other end of the front optical circuit board 7-12 is located on the side wall of the guide plate blocking hole 7-2, and the front optical circuit board 7-12 is a part of the propagation optical path.

Further the upper and lower surfaces of the switch light guide plate 7 are covered with a reflective film respectively wherein one reflective film is provided with a right front reflective hole 6-5 and a left front reflective hole 6-4 penetrating through the plate surface of the switch light guide plate 7, and the right front reflective hole 6-5 and the left front reflective hole 6-4 correspond to the right front optical path hole 7-11 and the left front optical path hole 7-10 respectively;
the reflective film is provided with an outward extending right front extension film 6-8 and a left front extension film 6-7 at the edges of the right front reflective hole 6-5 and the left front reflective hole 6-4 near the front optical circuit board 7-12 respectively; the right front extension film 6-8 and the left front extension film 6-7 form an extension reflective film of the reflective film, and the extension reflective film of the reflective film is bonded with the other reflective film;
the left and right sections of the front optical circuit board 7-12 are covered by the left front extension film 6-7 and the right front extension film 6-8 respectively, and the left and right sections of the front optical circuit board 7-12 are formed by the formed right front reflective hole 6-5 and the left front reflective hole 6-4.

Further the switch light guide plate 7 is divided into a plurality of optical zones, and the optical signals in the plurality of optical zones are separated from each other; in each optical zone, multiple optical transmitters are connected to the optical paths of a group of optical receivers respectively or to the optical path of an optical receiver.

Further the optical switch module further comprises reflective films for reflecting optical signals, the reflective films for reflecting optical signals are provided on the upper and lower surfaces of the switch light guide plate 7, and the reflective films are provided with the extension reflective films;
the switch light guide plate 7 is provided with an opening reflective hole 7-13 penetrating through its plate surface, and the section formed by punching the formed opening reflective hole 7-13 is a guide plate end section 7-14, and the extension reflective films cover the guide plate end section 7-14 to form a light reflecting surface;
the included angle between the front guide optical path 7-15 and the guide plate end section 7-14 is equal to the included angle between the reflecting optical path 7-16 and the guide plate end section 7-14, so that the optical signal transmitted by the optical transmitter through the optical switch is transmitted via the guide plate end section 7-14 and the extension reflective films along the front guide optical path 7-15, the extension reflective films reflect the optical signal, and the reflected optical signal is connected to the optical receiver along the reflecting optical path 7-16.

Further the light guide plate consists of a light-transmitting light guide plate 13 and a switch light guide plate 7, and the light-transmitting light guide plate 13 is located above the switch light guide plate 7 wherein the light guide netted dots 13-1 are provided on the upper surface of the light-transmitting light guide plate 13, the optical signal transmitted by the optical transmitter is connected to the optical path of the light guide netted dots 13-1, and the light-transmitting light guide plate 13 is provided with a light-transmitting plate hole 13-3 penetrating through its plate surface; a blocking space (9-1) on the switch light guide plate 7 is aligned with the light-transmitting plate hole 13-3 on the light-transmitting light guide plate 13; the LED light-transmitting hole 13-2 provided on the light-transmitting light guide plate 13 is aligned with the LED switch hole 7-9 provided on the switch light guide plate 7, and the LED switch hole 7-9 and the LED light-transmitting hole 13-2 can accommodate the optical transmitter.

Further the optical switch module further comprises a light leakage blocking part, and the light leakage blocking part blocks the optical signal from leaking out of the optical switch.

### The present invention has the following positive effects:

The present invention provides a film optical switch with a simple manufacturing process and low production cost, specifically providing an ultra-thin film optical switch with long service life. The film optical switch can be widely used in the PC keyboard, thin membrane keyboard, and thin laptop keyboard. The thin membrane keyboard is widely used in medical equipment, industrial control equipment, and household appliances such as washing machines and microwave ovens.

### Brief description of the Drawings

To illustrate technical solutions in embodiments of the present invention or the prior art more clearly, accompanying drawings to be used for describing the embodiments or prior art are introduced briefly in the following. Apparently, the accompanying drawings in the following description are some embodiments of the present invention, and persons of ordinary skill in the art can derive other drawings from these accompanying drawings without creative efforts.
FIG. 1 is a perspective view of a 101-key laptop keyboard using the optical switch and the optical module according to the present invention;
FIG. 2 is a partial sectional view of A in FIG. 1;
FIG. 3 is an exploded perspective view of FIG. 2;
FIG. 4 is an exploded perspective view of FIG. 2;
FIG. 5 is a partial perspective view of the blocking switch plate 9 according to the present invention;
FIG. 6 is a perspective view of the FPC circuit board 10 according to the present invention;
FIG. 7 is a partial perspective view of the blocking switch plate 9 mounted on the FPC circuit board 10 according to the present invention;
FIG. 8 is a perspective view of the blocking middle contact 9-7 in FIG. 7 being pressed;
FIG. 9 is a front view of FIG. 2;
FIG. 10 is a B-B sectional view of FIG. 9;
FIG. 11 is a perspective view of the keycap 1 in FIG. 10 being pressed;
FIG. 12 is a perspective view of the array optical switch module 3 installed under the metal support plate 2 according to the present invention;
FIG. 13 is a perspective view of the blocking middle contact 9-7 in FIG. 12 being pressed;
FIG. 14 is a perspective view of the array optical switch module 3 according to the present invention;
FIG. 15 is a perspective view of the blocking middle contact 9-7 in FIG. 14 being pressed;
FIG. 16 is an exploded view of the array optical switch module 3 with 101 optical switches according to the present invention;
FIG. 17 is a front view of the switch light guide plate 7 with 101 optical switches according to the present invention;
FIG. 18 is a view of the upper surface of the switch light guide plate 7 in FIG. 17 covered with an upper reflective film 6;
FIG. 19 is a partial enlarged view of the blocking switch plate 9 with 101 optical switches according to the present invention;
FIG. 20 is a partial enlarged view of the FPC circuit board 10 with 101 optical switches according to the present invention;
FIG. 21 is a circuit diagram of 50 optical switches to 65 optical switches according to the present invention;
FIG. 22 is a circuit diagram of 50 optical switches to 65 optical switches with two feature signals according to the present invention;
FIG. 23 is a circuit diagram of 50 optical switches to 65 optical switches with three feature signals according to the present invention;
FIG. 24 is a front view of the array optical switch module 3 with 101 optical switches according to the present invention;
FIG. 25 is a D-D sectional view of FIG. 24;
FIG. 26 is an E-E sectional view of FIG. 24;
FIG. 27 is a front view of the distribution of exhaust grooves on the blocking switch plate 9 with 101 optical switches according to the present invention;
FIG. 28 is a front view of the distribution of exhaust grooves on the switch light guide plate 7 with 101 optical switches according to the present invention;
FIG. 29 is a front view of the distribution of exhaust grooves on the array optical switch module 3 with 101 optical switches according to the present invention;
FIG. 30 is a partial enlarged view of F in FIG. 29;
FIG. 31 is an enlarged perspective view of FIG. 30;
FIG. 32 is a perspective view of a 101-key laptop keyboard using another optical switch and optical module according to the present invention;
FIG. 33 is a partial sectional view of A in FIG. 32;
FIG. 34 is an exploded perspective view of FIG. 33;
FIG. 35 is another exploded perspective view of FIG. 33;
FIG. 36 is a perspective view of the array optical switch module 3 in FIG. 33;
FIG. 37 is an exploded perspective view of the switch light guide plate 7 and the upper and lower reflective films in FIG. 36;
FIG. 38 is a perspective view of the upper and lower reflective films covered on the switch light guide plate 7 in FIG. 37;
FIG. 39 is a perspective view of the blocking switch plate 9 used in the array optical switch module 3 in FIG. 33;
FIG. 40 is a perspective view of the positional relationship between the switch light guide plate 7 covered with the upper and lower reflective films in FIG. 38 and the blocking switch plate 9;
FIG. 41 is another exploded perspective view of FIG. 33;
FIG. 42 is a front view of FIG. 33;
FIG. 43 is an H-H sectional view of FIG. 42;
FIG. 44 is a perspective view of the keycap 1 in FIG. 43 being pressed;
FIG. 45 is a partially enlarged perspective view of the array optical switch module 3 in FIG. 32;
FIG. 46 is an exploded perspective view of the array optical switch module 3 in FIG. 32;
FIG. 47 is a front view of the switch light guide plate 7 of the array optical switch module 3 in FIG. 32;
FIG. 48 is a front view of the switch light guide plate 7 covered with the upper reflective film of the array optical switch module 3 in FIG. 32;
FIG. 49 is a partial enlarged view of FIG. 48;
FIG. 50 is a partial enlarged view of FIG. 47;
FIG. 51 is a schematic diagram of the switch light guide plate 7 covered with the upper reflective film in FIG. 50.

### Detailed Description of Embodiments

Technical solutions in embodiments of the present prevention will be clearly and completely described with reference to the drawings in the embodiments of the present invention. Apparently, the embodiments described below are part, not all, of the embodiments of the present invention. All other embodiments obtained by persons of ordinary skill in the art based on the embodiments of the present invention without creative efforts shall fall within the protection scope of the present invention.

### Embodiment 1

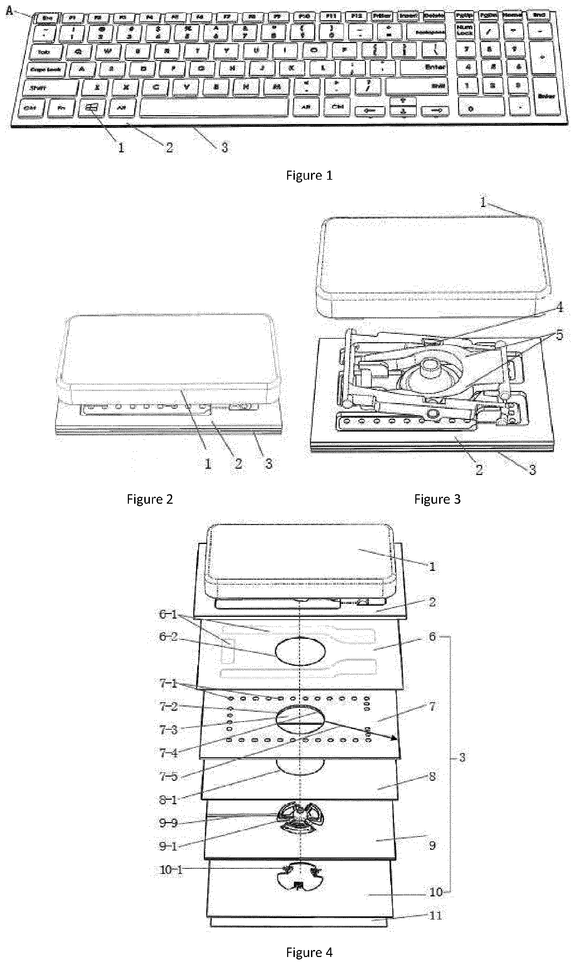

As shown in FIG. 1 - FIG. 15, a light guide plate optical switch and light guide plate array optical switch module, comprising an optical transmitter, an optical receiver, a circuit board, a light guide plate, and an optical switch, wherein the optical signal transmitted by the optical transmitter is connected to the optical path of the optical receiver through the propagation optical path on the light guide plate and the optical switch, and the optical path between the optical transmitter and the optical receiver is on/off when the optical switch is triggered; the light guide plate consists of a switch light guide plate 7, and the optical switch consists of a switch blocking body 9-1 on the blocking switch plate 9, an optical transmitter, an optical receiver, a switch light guide plate 7, and a guide plate blocking hole 7-2 on the switch light guide plate 7, wherein the optical transmitter consists of a light source part 10-1, and the light source part 10-1 is located in the guide plate blocking hole 7-2; the switch blocking body 9-1 consists of a switch blocking plate 9-2, a blocking connecting plate 9-4, a blocking lower through hole 9-5, a blocking arch spring 9-6, and a blocking middle body 9-8, wherein the lower end of the blocking arch spring 9-6 is connected to the plate surface of the blocking switch plate 9, the upper end of the blocking arch spring 9-6 is upwardly connected to the blocking middle body 9-8, and the blocking lower through hole 9-5 penetrates through the blocking arch spring 9-6 to form a space of the blocking lower through hole 9-5, or the blocking lower through hole 9-5 penetrates through the blocking arch spring 9-6 and the plate surface of the blocking switch plate 9 to form a space of the blocking lower through hole 9-5; the switch blocking plate 9-2 is connected to the blocking middle body 9-8 through the blocking connecting plate 9-4, and the blocking connecting plate 9-4 is aligned with the spatial position of the blocking lower through hole 9-5.

The array optical switch module of the light guide plate is provided with a blocking switch plate 9, the blocking switch plate 9 consists of a switch blocking body 9-1, and the switch blocking body 9-1 consists of a switch blocking plate 9-2, a blocking connecting plate 9-4, a blocking lower through hole 9-5, a blocking arch spring 9-6, and a blocking middle body 9-8; the lower end of the blocking arch spring 9-6 is connected to the plate surface of the blocking switch plate 9, the upper end of the blocking arch spring 9-6 is upwardly connected to the blocking middle body 9-8, and the elastic blocking arch spring 9-6 supports the blocking middle body 9-8; the blocking lower through hole 9-5 penetrates through the blocking arch spring 9-6 to form a space of the blocking lower through hole 9-5, or the blocking lower through hole 9-5 penetrates through the blocking arch spring 9-6 and the plate surface of the blocking switch plate 9 to form a space of the blocking lower through hole 9-5; the switch blocking plate 9-2 is arranged above the space of the blocking lower through hole 9-5 and the switch blocking plate 9-2 is connected to the blocking middle body 9-8 through the blocking connecting plate 9-4; when the blocking middle body 9-8 is pressed, the blocking middle body 9-8 moves downward against the elastic force generated by the blocking arch spring 9-6 and the blocking connecting plate 9-4 enters the space of the blocking lower through hole 9-5.

The optical switch consists of a switch blocking body 9-1 on the blocking switch plate 9, a light transmitting window of the optical transmitter, a light transmitting window of the optical receiver, a switch light guide plate 7, and a guide plate blocking hole 7-2 on the switch light guide plate 7, wherein the light transmitting window is located on the light receiving section 7-4 of the guide plate blocking hole 7-2 (used in this embodiment) when the light receiver is connected to the optical path of the guide plate blocking hole 7-2 through the switch light guide plate 7, the light transmitting window is located at the light transmitting end of the optical transmitter (used in this embodiment) when the optical transmitter is located in the guide plate blocking hole 7-2, or the light transmitting window is located on the light receiving section 7-4 when the optical transmitter is connected to the optical path of the guide plate blocking hole 7-2 through the switch light guide plate 7.

As shown in FIG. 1, this embodiment describes the light guide plate optical switch and light guide plate array optical switch module according to the present invention in detail by taking a 101-key laptop keyboard as an example (the array switch module is mostly used).

As shown in FIG. 1 -FIG. 3 (FIG. 2 is a partial sectional view of A in FIG. 1), the one-key key device shown in the figure consists of a keycap 1, a metal support plate 2, an array optical switch module 3, a reset body 4, and a pair of plastic supports 5, wherein the pair of plastic supports 5 are connected to the keycap 1 and the metal support plate 2 respectively to ensure that the keycap 1 can move up and down in parallel, the elastic reset body 4 abuts against the keycap 1 and the metal support plate 2 respectively and pushes the keycap 1 to the upper limit position (the highest position) under the action of elastic force.

The one-key key device of the existing laptop keyboard (not shown in the figure) consists of a keycap 1, a metal support plate 2, a reset body 4, a pair of plastic supports 5, and an array switch module (consisting of three layers of films, wherein the upper and lower layers of films are printed with silver paste circuits and the middle layer of film is a separation film), wherein the array switch module is located above and connected to the metal support plate 2, a light guide plate module for lighting the characters of the keycap 1 is located below and connected to the metal support plate 2, and the reset body 4 abuts against the keycap 1 and the light guide plate module respectively.

As shown in FIG. 4, the array optical switch module 3 according to the present invention is located below the metal support plate 2 of the laptop keyboard (the array optical switch module 3 can also make the characters of the keycap 1 give out light), and the array optical switch module 3 consists of an upper reflective film 6, a switch light guide plate 7, a lower reflective film 8, a blocking switch plate 9, and an FPC circuit board 10, wherein the switch light guide plate 7 is made of highly transparent materials (such as PC film, PMMA film, and glass film), the upper surface and the lower surface of the switch light guide plate 7 are covered with the upper reflective film 6 and the lower reflective film 8 respectively (the reflective film in this embodiment is a total dielectric reflective film, or a reflective aluminum film), the upper reflective film 6 and the lower reflective film 8 are helpful to reduce the optical loss of the optical signal in the switch light guide plate 7 (alternatively, the reflective film is not used, and the reflective film and magnetron sputtering reflective film are electroplated on the surface of the switch light guide plate 7 to reduce the optical loss), and the elastic blocking switch plate 9 (usually made of silicone rubber materials by injection molding) is located below the switch light guide plate 7; the blocking switch plate 9 is located between the switch light guide plate 7 and the FPC circuit board 10 and below the switch light guide plate 7 (used in this embodiment), and the FPC circuit board 10 is a 0.1 mm thick flexible printed circuit board; the upper reflective middle hole 6-2 penetrating through the upper reflective film 6 is aligned with the guide plate blocking hole 7-2 penetrating through the switch light guide plate 7 and the lower reflective middle hole 8-1 penetrating through the lower reflective film 8 respectively, and the diameter of the holes is the same; the guide plate blocking hole 7-2 is aligned with the switch blocking body 9-1 on the blocking switch plate 9 and the light source part 10-1 on the FPC circuit board 10 respectively, an opening space 7-3 of the guide plate blocking hole 7-2 can accommodate the switch blocking body 9-1, the hole section formed by punching the guide plate blocking hole 7-2 is a light receiving section 7-4 (a light transmitting window of the optical receiver), the optical signal is transmitted on the light receiving section 7-4 and is connected to the optical path of the optical receiver (photosensitive tube G in this embodiment) through a propagation optical path 7-5, and the propagation optical path 7-5 passes through the gap of the left front extension film 6-7 and is connected to the optical path of the optical receiver (when the optical signal is strong enough, the propagation optical path 7-5 can also pass under the left front extension film 6-7); a light guide netted dot part may (or may not) be provided on the upper surface of the switch light guide plate 7, the light guide netted dot part is composed of a left front extension film 6-7 formed by a plurality of circular points screen-printed with light guide ink on the upper surface of the switch light guide plate 7 or the light guide netted dot part is composed of a left front extension film 6-7 formed by a plurality of concave lenses hot-pressed on the upper surface of the switch light guide plate 7, and the light guide netted dot part is connected to the character optical path on the keycap 1 through the reflective light-transmitting part 6-1 penetrating through the reflective film 6 (through holes are used in this embodiment, the reflective film is usually used to form a layer of reflective material on the PET transparent sheet, and no reflective material is formed at the position corresponding to the light guide netted dot part - making it a light-transmitting and transparent area) and makes the characters transmit light.

As shown in FIG. 4 - FIG. 5, the plate-shaped blocking switch plate 9 is made of elastic materials and is provided with a switch blocking body 9-1, and the switch blocking body 9-1 consists of a switch blocking plate 9-2, a blocking upper space 9-3, a blocking connecting plate 9-4, a blocking lower through hole 9-5, a blocking arch spring 9-6, a blocking middle contact 9-7, and a blocking middle body 9-8, wherein the lower end of the blocking arch spring 9-6 is connected to the plate surface of the blocking switch plate 9, and the upper end of the blocking arch spring 9-6 is upwardly connected to the blocking middle body 9-8; in the figure, three blocking arch springs 9-6 are used to support the blocking middle body 9-8 (the blocking arch springs 9-6 are preferably at an angle of 120° to each other); two blocking arch springs 9-6 (not shown in the figure) can also be used to support the blocking middle body 9-8 (the blocking arch springs 9-6 are preferably at an angle of 180° to each other); one blocking arch spring 9-6 (not shown in the figure) can also be used to support the blocking middle body 9-8 (the blocking arch spring 9-6 is an integral part, preferably with a circle of about 240°, and a gap of about 60° is provided at 240°); the blocking lower through hole 9-5 formed by penetrating through the plate surface of the blocking switch plate 9 is located at the gap among/between the blocking arch springs 9-6 or the gap of the blocking arch spring 9-6, two blocking connecting plates 9-4 with one end connected to the supported blocking middle body 9-8 and the other end connected to the switch blocking plate 9-2 are arranged above the blocking lower through hole 9-5, the switch blocking plate 9-2 is formed by extending upward from the upper surfaces of the two blocking connecting plates 9-4, and the space enclosed by the supported blocking middle body 9-8, the two blocking connecting plates 9-4, and the switch blocking plate 9-2 is the blocking upper space 9-3.

It should be ensured that the blocking lower through hole 9-5 can accommodate the two blocking connecting plates 9-4;
it should be ensured that the connection of the blocking arch spring 9-6 upward with the blocking middle body 9-8 is in the same plane as the upper surfaces of the two blocking connecting plates 9-4, or the connection of the blocking arch spring 9-6 upward with the blocking middle body 9-8 is higher than the upper surfaces of the two blocking connecting plates 9-4;
it should be ensured that the switch blocking plate 9-2 is concentric with the blocking middle body 9-8;
when the external force is applied downward to the blocking middle contact 9-7, the blocking middle body 9-8 moves downward against the elastic force generated by the blocking arch spring 9-6 until the two blocking connecting plates 9-4 completely enter the lower end surfaces of the blocking lower through hole 9-5 and the blocking middle body 9-8, and the lower end surfaces of the two blocking connecting plates 9-4 coincide with the lower plate surfaces of the blocking switch plate 9; when the external force is removed, the blocking middle body 9-8 and the switch blocking plate 9-2 are reset under the action of the elastic force of the blocking arch spring 9-6.

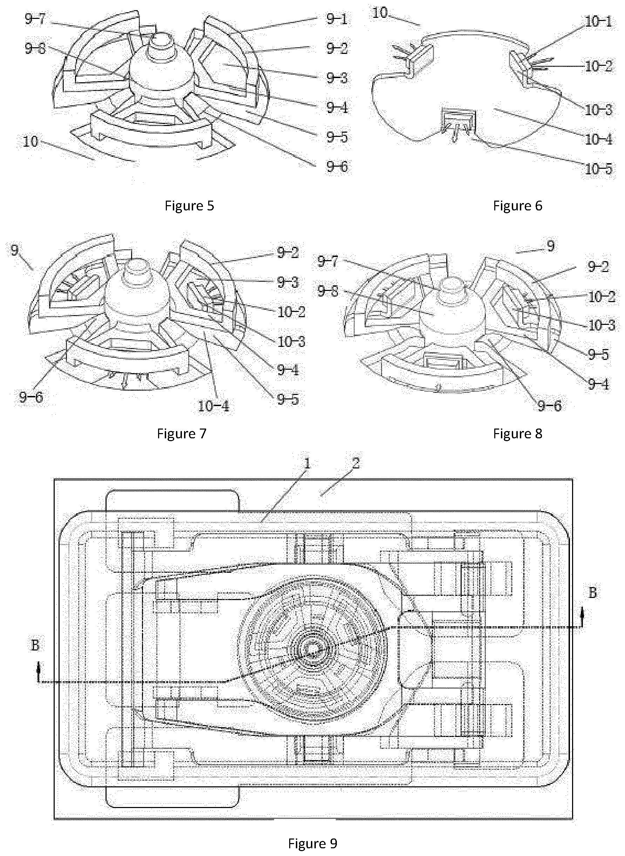

As shown in FIG. 4 and FIG. 6, the sheet-shaped flexible FPC circuit board 10 is provided with a light source part 10-1, and the optical transmitter is composed of the light source part 10-1;
the light source part 10-1 is composed of three side-lighted LEDs 10-2 (the LEDs 10-2 are preferably at an angle of 120° to each other);
the light source part 10-1 is composed of two side-lighted LEDs 10-2 (the LEDs 10-2 are preferably at an angle of 180° to each other);
the light source part 10-1 is composed of one side-lighted LED 10-2;
the light transmitting end of the LED 10-2 is a light transmitting window of the LED 10-2, and a LED through hole 10-4 penetrating through the board surface of the FPC circuit board 10 is provided in the opposite direction of the light transmitting window of the LED 10-2. In this embodiment, an FPC extension board 10-5 formed on the inwardly extending board surface of the FPC circuit board 10 is used, and an FPC SE plate 10-3 formed on the cantilever end of the FPC extension board 10-5 is provided with a COB-encapsulated LED chip to form the LED 10-2, and finally the FPC SE plate 10-3 is bent by 90° so that the LED 10-2 encapsulated on the FPC SE plate 10-3 becomes a light source for side lighting. The side-lighted LED 10-2 in this embodiment is composed of the COB-encapsulated LED chip on the 90° FPC SE plate 10-3.

As shown in FIG. 7 - FIG. 8, the lower surface of the blocking switch plate 9 is bonded with the upper surface of the FPC circuit board 10;
from the top view (from the top to the bottom):
it should be ensured that the LED 10-2 and the SE plate 10-3 on the FPC circuit board 10 are located in the blocking upper space 9-3 of the blocking switch plate 9;
it should be ensured that the blocking middle body 9-8 on the blocking switch plate 9 is located in the LED through hole 10-4 on the FPC circuit board 10.

As shown in FIG. 7, the optical signal transmitted by the LED 10-2 is transmitted from the space between the lower surface of the switch blocking plate 9-2 and the upper surface of the blocking switch plate 9.

As shown in FIG. 8, when the blocking middle contact 9-7 is pressed, the blocking arch spring 9-6 is elastically deformed, the blocking middle body 9-8 and the switch blocking plate 9-2 move downwards, and the switch blocking plate 9-2 blocks the optical signal transmitted by the LED 10-2.

FIG. 9 is a front view of a partial sectional view of A in FIG. 1.

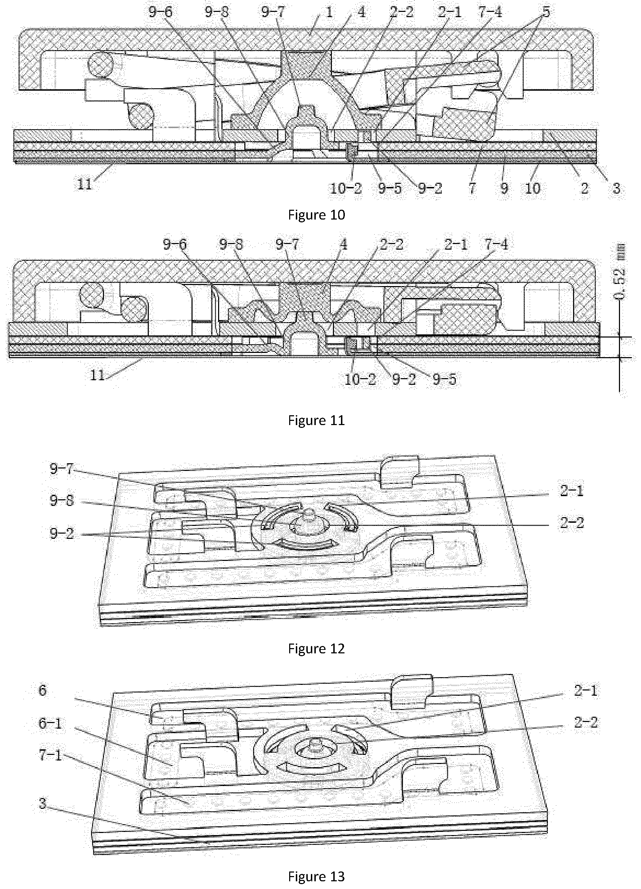

As shown in FIG. 10 and FIG. 12, when the keycap 1 is at the upper limit position, the blocking middle contact 9-7 and the upper part of the blocking middle body 9-8 of the blocking switch plate 9 are located in a support plate middle hole 2-2 penetrating through the plate surface near the middle of the metal support plate 2, the switch blocking plate 9-2 of the blocking switch plate 9 is located in a support plate outer hole 2-1 penetrating through the plate surface of the metal support plate 2, and the support plate outer hole 2-1 is located outside the support plate middle hole 2-2. The optical signal transmitted by the side-lighted LED 10-2 passes through the light receiving section 7-4 (the light transmitting window) on the switch light guide plate 7 to enter the switch light guide plate 7.

As shown in FIG. 10 and FIG. 11, to avoid the influence of the environment on the switch light guide plate 7, a thin sealing film 11 can be pasted on the lower surface of the FPC circuit board 10 (a 0.05 mm metal film is preferably used, which is conducive to the heat dissipation of the keyboard and also plays a sealing role). Meanwhile, the bottom surface of the reset body 4 (usually made of silicone rubber materials by injection molding) is hermetically connected to the upper surface of the metal support plate 2, and the upper surface of the array optical switch module 3 is hermetically connected to the lower surface of the metal support plate 2, to seal the space under the reset body 4, the space of the LED through hole 10-4, and the opening space 7-3, thus avoiding the optical loss caused by environmental pollution to the light receiving section 7-4 of the switch light guide plate 7, and the exhaust grooves (not shown in the figure) are arranged on the plate surface of the blocking switch plate 9 to avoid the influence on the pressing of the reset body 4 (e.g. difficulty in pressing the reset body 4).

The greatest advantage of the switch blocking body 9-1 according to the present invention is that the thickness of the array optical switch module 3 is minimized (as shown in FIG. 10, the thickness is only 0.52 mm). The greatest advantage of sealing the opening space 7-3 and other spaces according to the present invention is that the light incidence efficiency of the light receiving section 7-4 (the light transmitting window) of the switch light guide plate 7 is not reduced due to dust (especially when the optical switch is used for a long time).

As shown in FIG. 10 - FIG. 13, when the keycap 1 is pressed, the inner upper surface of the reset body 4 contacts the blocking middle contact 9-7 and pushes the blocking middle contact 9-7 to move downward together with the switch blocking plate 9-2 so that the blocking arch spring 9-6 is elastically deformed, the switch blocking plate 9-2 enters the blocking lower through hole 9-5 downward from the support plate outer hole 2-1, and the switch blocking plate 9-2 blocks the optical signal transmitted by the LED 10-2 from entering the switch light guide plate 7.

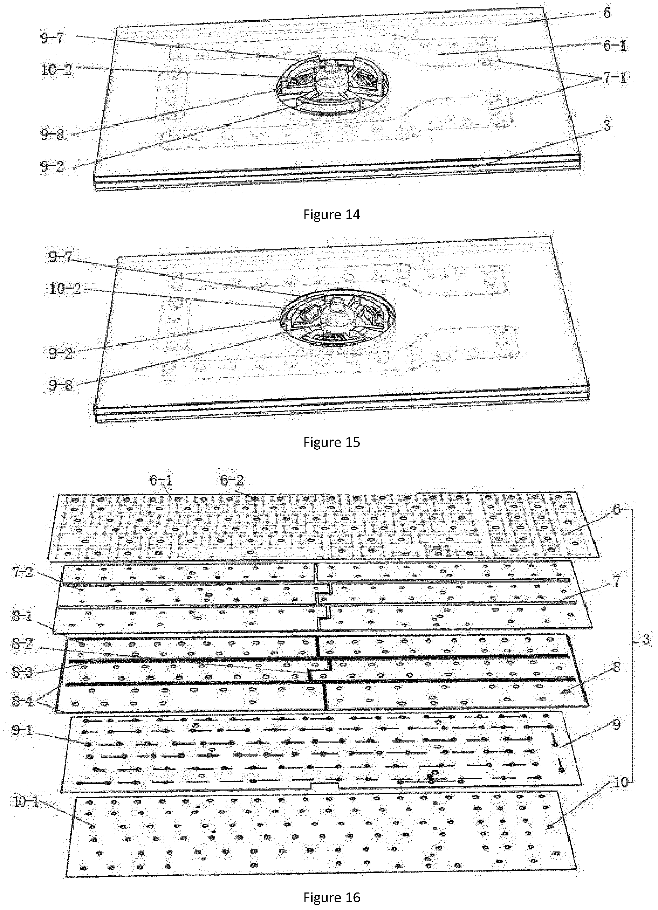

As shown in FIG. 14 - FIG. 15, when the blocking switch plate 9 of the array optical switch module 3 is at the upper limit position and the lower limit position, the switch blocking plate 9-2 has a positional relationship with the LED 10-2; the upper reflective middle hole 6-2, the guide plate blocking hole 7-2, and the lower reflective middle hole 8-1 are aligned and the diameter of the holes is the same; the light transmitted by the left front extension film 6-7 is transmitted from the transparent area - the reflective light-transmitting part 6-1 of the upper reflective film 6.

As shown in FIG. 16 - FIG. 17, this embodiment describes the light guide plate optical switch and light guide plate array optical switch module according to the present invention in detail by taking a 101-key laptop keyboard as an example (the array switch module is mostly used). The light guide plate array optical switch module has 101 optical switches arranged vertically and horizontally, wherein there are 20 optical switches in the first row, 18 optical switches in the second row, 18 optical switches in the third row, 16 optical switches in the fourth row, 16 optical switches in the fifth row, and 13 optical switches in the sixth row;
the array optical switch module 3 consists of an upper reflective film 6, a switch light guide plate 7, a lower reflective film 8, a blocking switch plate 9, and an FPC circuit board 10, wherein the switch light guide plate 7 is made of highly transparent materials, and the switch light guide plate 7 is divided into six optical zones including a 1 optical zone 7a, a 2 optical zone 7b, a 3 optical zone 7c, a 4 optical zone 7d, a 5 optical zone 7e, and a 6 optical zone 7f through the guide plate horizontal holes 7-7 and the guide plate vertical holes 7-8 penetrating through the plate surface of the switch light guide plate 7. In this embodiment, two guide plate horizontal holes 7-7 and three guide plate vertical holes 7-8 are used to separate the six optical zones from each other, the two guide plate horizontal holes 7-7 and the three guide plate vertical holes 7-8 form a guide plate exhaust groove, and the exhaust groove provided on the array optical switch module 3 consists of a guide plate exhaust groove and a blocking exhaust groove;
the 1 optical zone 7a is connected to 19 optical switches and the optical path of a guide plate light receiving part 7-6 through the light transmitting windows of 19 light source parts 10-1 (in this embodiment, the light transmitting windows are located at the light transmitting ends of the light source parts 10-1), and the guide plate light receiving part 7-6 is connected to the optical path of a photosensitive tube G; the guide plate light receiving part 7-6 may be composed of netted dots formed by a plurality of circular points screen-printed with light guide ink on the upper surface of the switch light guide plate 7, the guide plate light receiving part 7-6 may also be composed of netted dots formed by a plurality of concave lenses hot-pressed on the upper surface of the switch light guide plate 7, and the guide plate light receiving part 7-6 may also be formed by through holes penetrating through the plate surface;
the 2 optical zone 7b is connected to 18 optical switches, the guide plate light receiving part 7-6, and the optical path of a photosensitive tube G through the light transmitting windows of 18 light source parts 10-1, the 3 optical zone 7c is connected to 15 optical switches, the guide plate light receiving part 7-6, and the optical path of a photosensitive tube G through the light transmitting windows of 15 light source parts 10-1, the 4 optical zone 7d is connected to 14 optical switches, the guide plate light receiving part 7-6, and the optical path of a photosensitive tube G through the light transmitting windows of 14 light source parts 10-1, the 5 optical zone 7e is connected to 16 optical switches, the guide plate light receiving part 7-6, and the optical path of a photosensitive tube G through the light transmitting windows of 16 light source parts 10-1, and the 6 optical zone 7f is connected to 19 optical switches, the guide plate light receiving part 7-6, and the optical path of a photosensitive tube G through the light transmitting windows of 19 light source parts 10-1;
one light source part 10-1 in the 3 optical zone 7c (the number of the light source parts 10-1 is at least 13) is electrically connected to one light source part 10-1 in each of the other optical zones (in series or in parallel and their combinations) to form an OT group, and the above process is repeated to form 13 OT groups with six light source parts 10-1 electrically connected;
the remaining two light source parts 10-1 not electrically connected in the 4 optical zone 7d (the number of the light source parts 10-1 is 16) are electrically connected to one light source part 10-1 in each of the other optical zones to form 2 OT groups with five light source parts 10-1 electrically connected;
the remaining one light source part 10-1 in the 2 optical zone 7b and the 5 optical zone 7e (the number of the light source parts 10-1 is 17) is electrically connected to one light source part 10-1 in each of the other optical zones to form 1 OT group with four light source parts 10-1 electrically connected; the remaining one light source part 10-1 in the 1 optical zone 7a and the 6 optical zone 7f (the number of the light source parts 10-1 is 19) is electrically connected to one light source part 10-1 in each of the other optical zones to form 2 OT groups with three light source parts 10-1 electrically connected.

As shown in FIG. 16 - FIG. 20, the CPU has an on/off interface and a detection interface; the light guide plate is divided into a plurality of optical zones, and the optical signals in the plurality of optical zones are separated from each other;
in each optical zone, multiple optical transmitters are connected to the optical paths of a group of optical receivers respectively or to the optical path of an optical receiver;
the optical transmitter is connected to the on/off interface, and the optical receiver is connected to the detection interface;
during use, the CPU continuously detects the signals of multiple detection interfaces; when an optical switch in a certain optical zone is pressed, the CPU judges whether an optical switch in a certain optical zone is pressed by detecting the detection interface.

The light guide plate is divided into a plurality of optical zones, and the optical signals in the plurality of optical zones are separated from each other; in each optical zone, multiple optical transmitters are connected to the optical paths of a group of optical receivers respectively or to the optical path of an optical receiver; the optical transmitter is connected to a CPU output interface, the optical receiver is connected to a CPU input interface, and the optical transmitter in each optical zone transmits the optical signals that can be recognized by the CPU;
during use, when an optical switch in a certain optical zone is pressed, the CPU judges whether an optical switch in a certain optical zone is pressed by detecting the CPU input interface.

The light guide plate consists of a switch light guide plate (7); the optical transmitter and the CPU output interface are connected as follows: an optical transmitter in one optical zone is connected to an optical transmitter in another optical zone to form an OT group...the above connection process is repeated to form a plurality of OT groups, and the plurality of OT groups are connected to a plurality of CPU output interfaces respectively, thus ensuring that at most only one optical transmitter of the multiple optical transmitters in each optical zone transmits the optical signal at every moment or when the CPU detects the CPU input interface.

The switch light guide plate 7 is divided into at least two optical zones, and the two optical zones are a 1 optical zone 7a and a 2 optical zone 7b, wherein the optical signal in the 1 optical zone 7a is separated from the optical signal in the 2 optical zone 7b; the light transmitting windows of multiple optical transmitters in the 1 optical zone 7a are connected to multiple optical switches and the optical path of an optical receiver G1, and the light transmitting windows of multiple optical transmitters in the 2 optical zone 7b are connected to multiple optical switches and the optical path of an optical receiver G2; one optical transmitter in the 1 optical zone 7a is connected to one optical transmitter in the 2 optical zone 7b to form a connected OT group, and a 1 OT group, a 2 OT group, a 3 OT group... a n OT group are connected to a 1CPU output interface, a 2CPU output interface, a 3CPU output interface... a nCPU output interface respectively; the optical receiver G1 and the optical receiver G2 are connected to a 1CPU input interface and a 2CPU input interface of the CPU respectively; during use, the CPU continuously detects the signals of the 1CPU input interface and the 2CPU input interface; when an optical switch in the 1 optical zone 7a is pressed, the CPU determines the change of the optical signal in the 1 optical zone 7a by detecting the 1CPU input interface, and the CPU judges whether an optical switch in the 1 optical zone 7a is pressed based on the change of the optical signal; when an optical switch in the 2 optical zone 7b is pressed, the CPU determines the change of the optical signal in the 2 optical zone 7b by detecting the 2CPU input interface, and the CPU judges whether an optical switch in the 2 optical zone 7b is pressed based on the change of the optical signal.

The light guide plate array optical switch module further comprises a CPU, wherein the CPU has a plurality of output interfaces and a plurality of input interfaces, the connected OT group is connected to the output interface through the CPU output interface, and the optical receiver is connected to the input interface through the CPU input interface; the CPU output interface and the CPU input interface are located on the same circuit board as the output interface and the input interface, or the CPU output interface and the CPU input interface are located on different circuit boards from the output interface and the input interface.

The CPU continuously scans and detects each CPU input interface circularly or continuously detects each CPU input interface simultaneously, and when the CPU detects the signal change of an output interface, the CPU judges whether an optical switch is triggered based on the optical zone where an OT group connected to the CPU output interface and the optical transmitter connected to the OT group are located.

When the array optical switch module works, the CPU is connected to a CPU output interface, and an OT group connected to the CPU output interface has at most only one optical transmitter in each optical zone to transmit the optical signals; one group of optical receivers in each optical zone receive the optical signals or one optical receiver receives the optical signals, each CPU input interface connected to the OT group has signal input, CPU judges whether an optical switch in each optical zone is triggered, and the CPU closes the CPU output interface;
the CPU is connected to another CPU output interface, and an OT group connected to the CPU output interface has at most only one optical transmitter in each optical zone to transmit the optical signals; one group of optical receivers in each optical zone receive the optical signals or one optical receiver receives the optical signals, each CPU input interface connected to the OT group has signal input, CPU judges whether an optical switch in each optical zone is triggered, and the CPU closes the CPU output interface;
the above process is repeated continuously;
when an optical switch is triggered, the optical path in the optical zone is blocked, so that the optical receiver in the optical zone cannot receive the optical signal, no signal input is available from the CPU input interface connected to the optical receiver, and the CPU judges the position of the optical switch based on the connected OT group and the corresponding relationship between the optical zone and the optical receiver.

The CPU output interfaces of the CPU transmit different feature signals, and the optical transmitters connected to the OT group transmit different feature signals in the same optical zone.

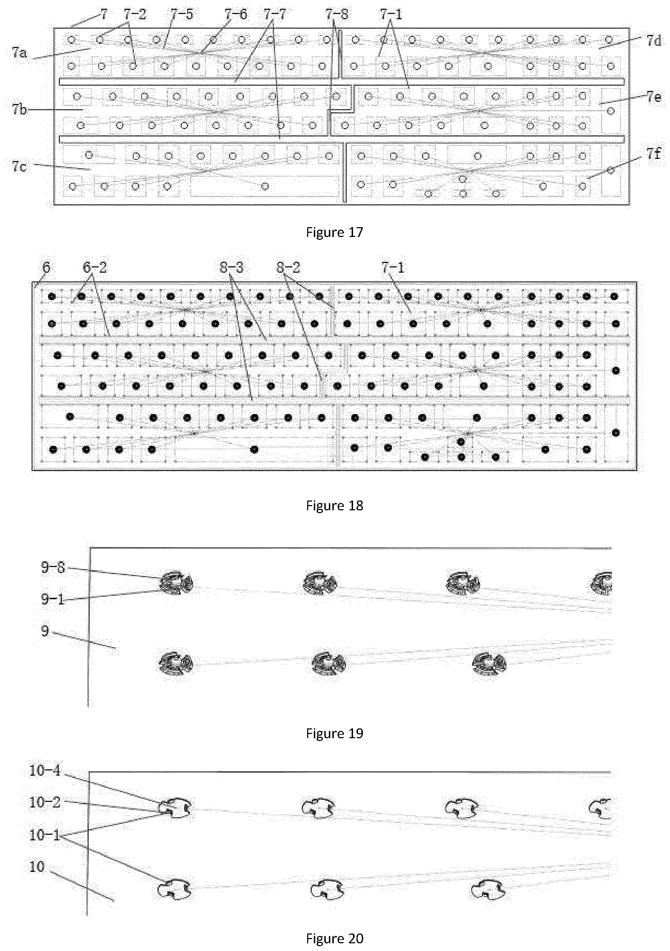

As shown in FIG. 19 - FIG. 20, the switch blocking body 9-1 on the blocking switch plate 9 is arranged vertically and horizontally; the light source part 10-1 on the FPC circuit board 10 is arranged vertically and horizontally; the blocking middle body 9-8 provided on the switch blocking body 9-1 is located in the LED through hole 10-4 of the light source part 10-1.

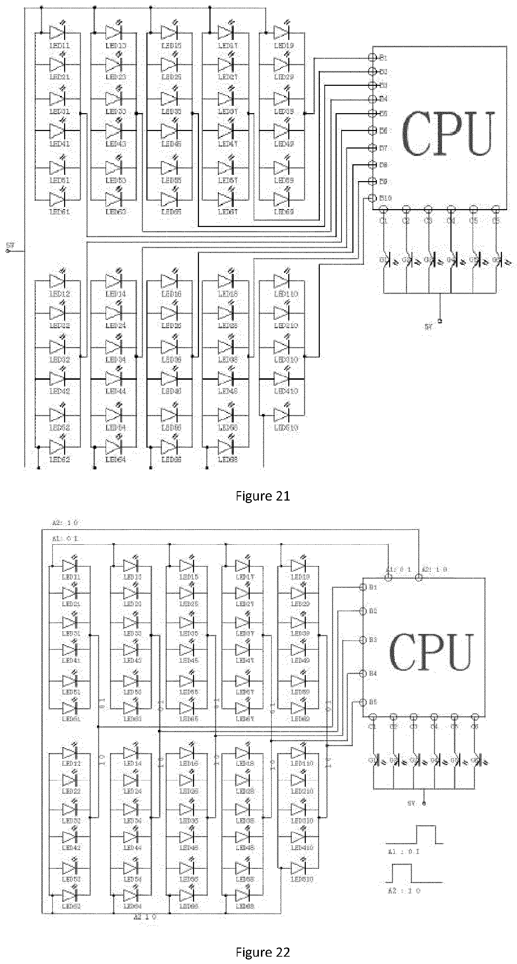

As shown in FIG. 21 (since the A4 paper is too small, only 59 switches are drawn in the circuit diagram), the CPU needs 10 I/O interfaces in total (the CPU needs 10 input interfaces B and 6 input interfaces C, the switch light guide plate 7 is divided into six optical zones, and each optical zone needs one photosensitive tube G); in this embodiment, taking the circuit of the light guide plate array optical switch module with 101 optical switches as an example, the CPU used by 101 optical switches needs 20 output interfaces in total, and the output interfaces are B1, B2.... B20 (B11, B12.... B20 and the circuits electrically connected to them are not shown in the figure); the input interfaces of the six photosensitive tubes G are connected to C1, C2.... C6 respectively;
an optical transmitter in one optical zone is connected to an optical transmitter in another optical zone to form a LED group in which a maximum number of the optical transmitters in each optical zone are connected to each other.

In the six optical zones:
The LED group with the LED serial number of 1 in each optical zone is a 1LED group (the OT group consists of the LED groups), the 1LED group consists of LED11, LED21, LED31, LED41, LED51, and LED61 that are electrically connected (n in the LEDnm indicates that the LED is located in the n optical zone and m indicates the serial number of the optical zone where the LED is located) (in the figure, the electrical connection is the parallel connection, and in actual application, serial connection or parallel connection and its combination are allowed), and the 1LED group is connected to B1 of the CPU;
the 2LED group consists of LED12, LED22, LED32, LED42, LED52, and LED62 that are electrically connected, and the 2LED group is connected to B2 of the CPU;
the 20LED group consists of LED110, LED210, LED310, LED410, LED510, and LED610 that are electrically connected, and the 20LED group is connected to B20 of the CPU;
in the figure, G1, G2, G3... are photosensitive tubes G, G1, G2, G3... that are connected to the input interface C1, the input interface C2, the input interface C3... respectively.

101 optical switches are provided with 101 LEDs, and the CPU needs 101 output interfaces in total if the division of the optical zone is not carried out and the LED group circuit structure is not used. According to the present invention, the division of the optical zone is carried out and the LED group circuit structure is used. The CPU used by 101 LEDs needs 20 output interfaces in total so that the number of output interfaces is greatly reduced and the electronic circuit is greatly simplified; meanwhile, the CPU needs 20 output interfaces in total so that the scanning and detection speed of the CPU is increased by more than 5 times.

Due to the different number of optical switches provided on the light guide plate array optical switch module and the different number of optical zones provided on the switch light guide plate 7, it is possible that there is only one light source part 10-1 in one OT group;
the 1 receiver G1 in the 1 optical zone 7a, 2 receiver G2 in the 2 optical zone 7b... 6 receiver G6 in the 6 optical zone 7f are connected to the input interface C1, the input interface C2... the input interface C6 respectively.

During use, the CPU turns on the 1LED, and at this time, the 1LED has at most only one light source part 10-1 in each optical zone to transmit the optical signals; meanwhile, the CPU continuously detects the signals of the input interface C1, the input interface C2... the input interface C6 to judge whether the optical signals are changed to determine which keycap is pressed;
the CPU turns on the 2LED, and at this time, the 1LED has at most only one light source part 10-1 in each optical zone to transmit the optical signals; meanwhile, the CPU continuously detects the signals of the input interface C1, the input interface C2... the input interface C6 to judge whether the optical signals are changed to determine which keycap is pressed;
the CPU repeats the above detection continuously.
The 1 output interface of the CPU transmits an optical signal, and when an optical switch in the 1 optical zone 7a is pressed, the input interface C1 detects the change of the optical signal in the 1 optical zone 7a, so that the CPU judges whether an optical switch in the 1 optical zone 7a is pressed based on the change of the optical signal;
the 2 output interface of the CPU transmits an optical signal, and when an optical switch in the 2 optical zone 7b is pressed, the input interface C2 detects the change of the optical signal in the 2 optical zone 7b, so that the CPU judges whether an optical switch in the 2 optical zone 7b is pressed based on the change of the optical signal;
the CPU repeats the scanning and detection continuously.

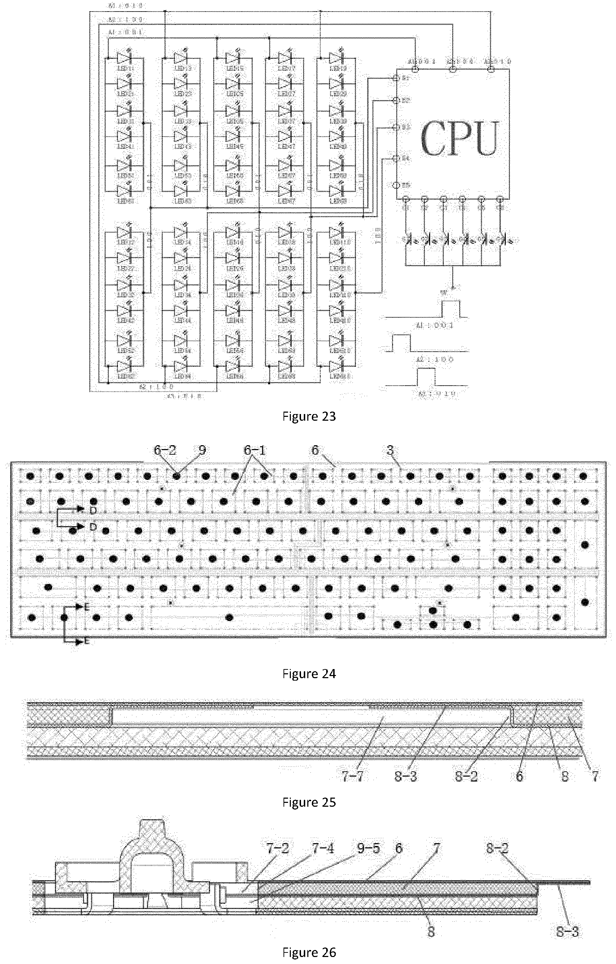

As shown in FIG. 22, to reduce the number of CPU I/O interfaces and simplify the circuit, the CPU is provided with feature output interfaces - a feature output interface A1 and a feature output interface A2 on the basis of the circuit diagram in FIG. 24,
the CPU used by 101 optical switches needs 10 output interfaces in total, and the output interfaces are B1, B2, B3, B4... B10 (B6, B7... B10 and the circuits electrically connected to them are not shown in the figure); the input interfaces are C1, C2... C6, the feature output interfaces are A1 and A2, and the CPU needs 17 I/O interfaces in total;
the 1LED group consists of LED11, LED21, LED31, LED41, LED51, and LED61 that are electrically connected;
the 2LED group consists of LED12, LED22, LED32, LED42, LED52, and LED62 that are electrically connected;
the above two LED groups are connected together to form a LED feature group, and the LED feature group is connected to B1;
the 3LED group consists of LED13, LED23, LED33, LED43, LED53, and LED63 that are electrically connected;
the 4LED group consists of LED14, LED24, LED34, LED44, LED54, and LED64 that are electrically connected;
the above two LED groups are connected together to form a LED feature group, and the LED feature group is connected to B2;
the above two LED groups are connected together to form a LED feature group, and the LED feature group is connected to B5;
the CPU has two feature output interfaces transmitting different feature signals: a feature output interface A1 and a feature output interface A2,
the feature output interface A1 is connected to a plurality of LED groups, and the feature output interface A2 is connected to a plurality of LED groups;
two LED groups are connected to form a LED feature group, wherein each LED group forming the LED feature group transmits different feature signals,
the 1LED feature group is connected to the output interface B1, and the output interface B1 controls the on/off of the 1LED feature group; the 1LED feature group is composed of two LED groups, and the two LED groups transmit different feature signals,
the 2LED feature group is connected to the output interface B2, and the output interface B2 controls the on/off of the 2LED feature group; the 2LED feature group is composed of two LED groups, and the two LED groups transmit different feature signals,
the 3LED feature group is connected to the output interface B3, and the output interface B3 controls the on/off of the 3LED feature group; the 3LED feature group is composed of two LED groups, and the two LED groups transmit different feature signals,

As shown in FIG. 23, to further reduce the number of CPU I/O interfaces and simplify the circuit, the CPU is provided with a feature output interface, and the feature output interface consists of a feature output interface A1, a feature output interface A2, and a feature output interface A3 on the basis of the circuit diagram in FIG. 22. In this embodiment, by taking only two to three feature signals as an example (the feature signals can also be four or five), the CPU used by 101 optical switches needs 8 output interfaces in total, the output interfaces are B1, B2... B8, and the input interfaces are C1, C2... C6; the CPU used by 101 optical switches needs 17 I/O interfaces and 5 output interfaces in total so that the number of output interfaces is further reduced greatly (from 20 output interfaces to 10 output interfaces for the CPU in the solution shown in FIG. 24) and the electronic circuit is further simplified greatly, and meanwhile, the CPU needs 10 output interfaces in total so that the scanning and detection speed of the CPU is increased by more than 10 times.

The CPU has three feature output interfaces transmitting different feature signals: a feature output interface A1, a feature output interface A2, and a feature output interface A3,
the feature output interface A1 is connected to a plurality of LED groups, the feature output interface A2 is connected to a plurality of LED groups, and the feature output interface A3 is connected to a plurality of LED groups;
three LED groups are connected to form a LED feature group, wherein each LED group forming the LED feature group transmits different feature signals,
the 1LED feature group is connected to the output interface B1, and the output interface B1 controls the on/off of the 1LED feature group; the 1LED feature group is composed of three LED groups, and each LED group transmits different feature signals,
the 2LED feature group is connected to the output interface B2, and the output interface B2 controls the on/off of the 2LED feature group; the 2LED feature group is composed of three LED groups, and each LED group transmits different feature signals,
the 3LED feature group is connected to the output interface B3, and the output interface B3 controls the on/off of the 3LED feature group; the 3LED feature group is composed of three LED groups, and each LED group transmits different feature signals,...

As shown in FIG. 16 - FIG. 18 and FIG. 22 - FIG. 23, the light guide plate is divided into a plurality of optical zones, and the optical signals in the plurality of optical zones are separated from each other; in each optical zone, multiple optical transmitters are connected to the optical paths of a group of optical receivers respectively or to the optical path of an optical receiver, and the optical receivers in each optical zone are connected to the signal input interfaces of the CPU respectively; an optical transmitter in one optical zone is connected to an optical transmitter in another optical zone to form an OT group in which at most one optical transmitter in each optical zone is connected... the above connection process is repeated to form a plurality of OT groups;
the CPU has feature output interfaces transmitting multiple different feature signals, wherein each feature output interface is connected to a plurality of OT groups, the plurality of OT groups are connected to form an OT feature group, and each OT group forming the OT feature group transmits different feature signals; multiple OT feature groups are connected to multiple optical input interfaces of the CPU respectively, and the on/off of each OT feature group is controlled by one optical input interface of the CPU; during use, the CPU continuously detects the signals of the signal input interfaces.

The light guide plate is divided into n optical zones: a 1 optical zone 7a, a 2 optical zone 7b, a 3 optical zone 7c... n optical zone respectively, and the optical signals in the optical zones are separated from each other;
multiple optical transmitters in the 1 optical zone 7a are connected to the optical path of the optical receiver G1,
multiple optical transmitters in the 2 optical zone 7b are connected to the optical path of the optical receiver G2,
multiple optical transmitters in the 3 optical zone 7c are connected to the optical path of the optical receiver G3, ...;
one optical transmitter in the 1 optical zone 7a, one optical transmitter in the 2 optical zone 7b, one optical transmitter in the 3 optical zone 7c... are electrically connected to form an OT group, and the above connection process is repeated to form a 1 OT group, 2 OT group, 3 OT group...;
the CPU has feature output interfaces transmitting multiple different feature signals, wherein each feature output interface is connected to a plurality of OT groups, the plurality of OT groups are connected to form a LED feature group, and the optical transmitters of the LED feature group in the same optical zone transmit different feature signals;
multiple LED feature groups are connected to multiple output interfaces of the CPU respectively, the on/off of each LED feature group is controlled by one output interface of the CPU, and the output interface consists of an output interface B1, an output interface B2, an output interface B3...,
the 1LED feature group is connected to the output interface B1 of the CPU, and the output interface B1 controls the on/off of the 1LED feature group,
the 2LED feature group is connected to the output interface B2 of the CPU, and the output interface B2 controls the on/off of the 2LED feature group,
the 3LED feature group is connected to the output interface B3 of the CPU, and the output interface B3 controls the on/off of the 3LED feature group...,
the optical receiver G1 in the 1 optical zone 7a, the optical receiver G2 in the 2 optical zone 7b, the optical receiver G3 in the 3 optical zone 7c... are connected to the input interface C1 of the CPU, the output interface B2 of the CPU, the input interface C3, and the input interface C3 of the CPU... respectively;
during use, the CPU continuously detects the signals of the input interface C1, the output interface B2, the input interface C3...

The greatest advantages of dividing the light guide plate into a plurality of optical zones and electrically connecting one light source part 10-1 in each optical zone are as follows:
1. The power of the array optical switch is greatly reduced: The power of each optical switch for scanning detection in the present invention is determined by the power of each OT group. During the detection by the CPU (taking the light guide plate divided into 6 optical zones as an example), at most 6 light source parts 10-1 (the power of each LED is 0.06 W, and the total power is 0.36 W) of an OT group according to the present invention are lit up, so the power is reduced by 6/101 times compared with the power of 6.06 W when 101 light source parts 10-1 are lit up simultaneously. The power of the existing laptop is generally 55 W - 60 W, and there is a general problem that heat causes its performance to decline. If only the photoelectric keyboard increases the power by about 10%, it is difficult to promote;
2. The number of CPU I/O interfaces is greatly reduced and the electronic circuit is greatly simplified

The 101-key keyboard is provided with 101 optical switches - 101 light source parts 10-1 and 101 photosensitive tube G (the circuit is complex, so multilayer PCB is used to complete the circuit wiring). According to the present invention, the light guide plate is divided into 6 optical zones and the OT group solution is used. In this embodiment, 101 optical switches only need 20 output interfaces and 6 input interfaces, as shown in FIG. 21, and 26 CPU I/O interfaces are needed in total;
the CPU is provided with two feature output interfaces. In this embodiment, 101 optical switches only need 10 output interfaces and 6 input interfaces, as shown in FIG. 21, and 18 CPU I/O interfaces are needed in total.

### 3. All keys have no key conflict:

The output interfaces of the CPU transmit different feature signals. When more than two keys in the same optical zone are pressed simultaneously, the CPU fails to distinguish the film array switch circuit technology of the existing keyboard with more than two keys pressed simultaneously in the same optical zone, so the input interfaces are added to solve this problem. For example, for the commonly used key combination Ctrl+A, the Ctrl is separately connected to one input interface of the CPU, as shown in FIG. 21, and each output interface B of the CPU transmits different feature signals; similar to the TV remote controller, when each key is pressed, the TV remote controller transmits different feature signals. The solution for the CPU with 20 output interfaces and 101 optical switches transmits different feature signals to 20 groups of light source parts 10-1, and the CPU receives different feature signals to distinguish the keys in the same optical zone. In the present invention, no key conflict can be achieved for the whole keyboard, and any n keys pressed simultaneously can be recognized by the CPU, so it is especially suitable for people playing games.

The greatest advantages of using optical switches are as follows:
1. The cost of the array switch is greatly reduced

The optical switches are added to the light guide module and 101 light source parts 10-1 are added with the cost of RMB 0.03 per light source part 10-1, and the film array switch circuit printed with silver paste is not used with the cost of RMB 8 - 12 per film array switch circuit.

### 2. The service life of the switch is greatly prolonged

The existing film array switch circuit is installed on the metal support plate 2, the film array switch circuit has as many openings as the metal support plate 2, and the film array switch circuit has a complicated waterproof process and poor reliability. The light guide module according to the present invention is installed under the metal support plate 2, with fewer process openings, simple waterproof process, and outstanding waterproof performance.

As shown in FIG. 24 - FIG. 26, the upper reflective film 6 and the lower reflective film 8 are covered on the upper surface of the switch light guide plate 7 and the lower surface of the switch light guide plate 7 respectively; the lower reflective film 8 is provided with the through holes at the positions aligned with the guide plate horizontal holes 7-7 and the guide plate vertical holes 7-8 of the switch light guide plate 7, the through holes have the same size as the guide plate horizontal holes 7-7 and the guide plate vertical holes 7-8, and the through holes are provided with extension edges; the overall dimension of the lower reflective film 8 is the same as that of the upper reflective film 6, the extension edges are arranged around the lower reflective film 8, and after the upper plane of the lower reflective film 8 is attached to the lower surface of the switch light guide plate 7, the extension edges are bonded to the lower surface of the upper reflective film 6 to form a lower horizontal reflective extension edge 8-3 and a lower vertical reflective extension edge 8-2, wherein the extension reflective film is formed by the lower horizontal reflective extension edge 8-3 and the lower vertical reflective extension edge 8-2, the lower horizontal reflective extension edge 8-3 is bonded to the lower surface of the upper reflective film 6, and the lower vertical reflective extension edge 8-2 covers a section perpendicular to the upper and lower surfaces of the switch light guide plate 7; the section covered on the switch light guide plate 7 is to reduce the optical loss (after the light is transmitted to the section of the switch light guide plate 7, it is reflected back into the switch light guide plate 7 by the lower vertical reflective extension edge 8-2), and meanwhile, the lower vertical reflective extension edge 8-2 separates each optical zone.

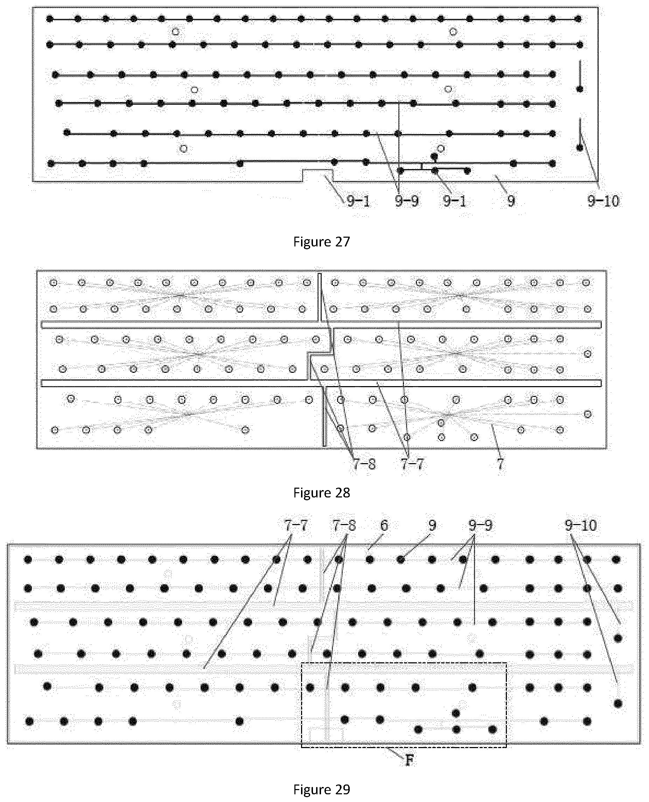

As shown in FIG. 27 - FIG. 28, the array optical switch module 3 is provided with the exhaust grooves, and the exhaust grooves include a blocking exhaust groove arranged on the blocking switch plate 9 and a switch plate exhaust groove arranged on the switch light guide plate 7; the blocking exhaust groove is composed of blocking horizontal exhaust grooves 9-9 and blocking vertical exhaust grooves 9-10, wherein each row of blocking horizontal exhaust grooves 9-9 arranged horizontally are connected to all the blocking lower through holes 9-5 of the blocking switch plate 9 in each row, and the blocking vertical exhaust grooves 9-10 are connected to the blocking lower through holes 9-5 of the blocking switch plate 9;

The switch plate exhaust groove is composed of the guide plate horizontal holes 7-7 and the guide plate vertical holes 7-8.

As shown in FIG. 29 - FIG. 31, when the switch light guide plate 7 and the blocking switch plate 9 are stacked together, the blocking horizontal exhaust grooves 9-9 are connected to the guide plate vertical holes 7-8, and the blocking vertical exhaust grooves 9-10 are connected to the guide plate horizontal holes 7-7; an exhaust gap 9-11 penetrating through the plate surface of the switch light guide plate 7 is arranged on the switch light guide plate 7, and it should be ensured that the exhaust gap 9-11 is aligned with the switch plate exhaust groove and is connected in space; in this embodiment, the exhaust gap 9-11 is aligned with the lower position of the blocking vertical exhaust grooves 9-10 and connected in space; an air filter material 12 made of air filter materials is arranged in the exhaust gap 9-11, and the exhaust grooves are connected to the atmosphere through the air filter material 12; the array optical switch module 3 is provided with the exhaust grooves, which solves the difficulty of pressing the reset body 4 after the optical switch is fully sealed.

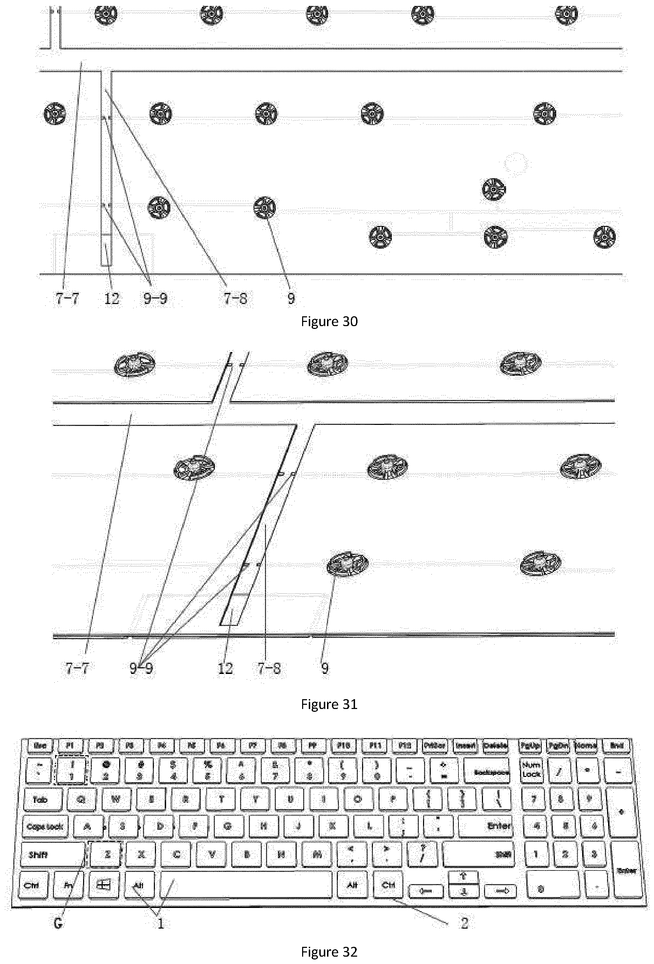

**In Embodiment 2,** as shown in FIG. 32 - FIG. 44, the light guide plate consists of a switch light guide plate 7, and the switch light guide plate 7 is provided with the light guide plate through holes penetrating through its plate surface; the light guide plate through holes consist of a LED switch hole 7-9, a guide plate blocking hole 7-2, a left front optical path hole 7-10, and a right front optical path hole 7-11, wherein the optical transmitter is a side-lighted optical transmitter, the optical transmitter is located in the LED switch hole 7-9, and the left front optical path hole 7-10 and the right front optical path hole 7-11 penetrate through the plate surface of the switch light guide plate 7 to form a front optical circuit board 7-12 between the left front optical path hole 7-10 and the right front optical path hole 7-11; one end of the front optical circuit board 7-12 is located on the side wall of the LED switch hole 7-9 and is connected to the optical path of the optical transmitter and the other end of the front optical circuit board 7-12 is located on the side wall of the guide plate blocking hole 7-2, and the front optical circuit board 7-12 is a part of the propagation optical path.

The upper and lower surfaces of the switch light guide plate 7 are covered with a reflective film respectively, wherein one reflective film is provided with a right front reflective hole 6-5 and a left front reflective hole 6-4 penetrating through the plate surface of the switch light guide plate 7, and the right front reflective hole 6-5 and the left front reflective hole 6-4 correspond to the right front optical path hole 7-11 and the left front optical path hole 7-10 respectively; the reflective film is provided with an outward extending right front extension film 6-8 and a left front extension film 6-7 at the edges of the right front reflective hole 6-5 and the left front reflective hole 6-4 near the front optical circuit board 7-12 respectively; the right front extension film 6-8 and the left front extension film 6-7 form an extension reflective film of the reflective film, and the extension reflective film of the reflective film is bonded with the other reflective film;
the left and right sections of the front optical circuit board 7-12 are covered by the left front extension film 6-7 and the right front extension film 6-8 respectively, and the left and right sections of the front optical circuit board 7-12 are formed by the formed right front reflective hole 6-5 and the left front reflective hole 6-4; the optical switch module further comprises a light leakage blocking part, and the light leakage blocking part blocks the optical signal from leaking out of the optical switch.

As shown in FIG. 32, this embodiment describes the light guide plate optical switch and light guide plate array optical switch module according to the present invention in detail by taking a 101-key laptop keyboard as an example (the array switch module is mostly used).

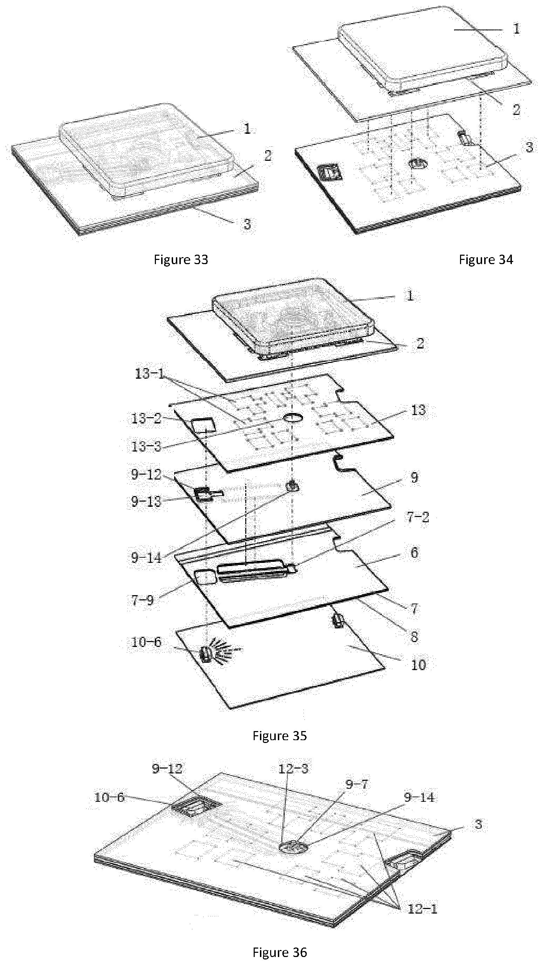

As shown in FIG. 33 - FIG. 34 (FIG. 33 is a partial sectional view of G in FIG. 31), the one-key key device shown in the figure consists of a keycap 1, a metal support plate 2, an array optical switch module 3, a reset body 4 (not shown in the figure), and a pair of plastic supports 5 (not shown in the figure).

As shown in FIG. 35, the array optical switch module 3 according to the present invention is located below the metal support plate 2 of the laptop keyboard, and the array optical switch module 3 consists of an upper reflective film 6, a switch light guide plate 7, a lower reflective film 8, a blocking switch plate 9, an FPC circuit board 10, and a light-transmitting light guide plate 13, wherein the upper surface and the lower surface of the switch light guide plate 7 are covered with the upper reflective film 6 and the lower reflective film 8 respectively; in this embodiment, the switch light guide plate 7 is located between the blocking switch plate 9 and the FPC circuit board 10 and above the FPC circuit board 10 (the blocking switch plate 9 is located above the switch light guide plate 7) and the light-transmitting light guide plate 13 is located above the blocking switch plate 9.

As shown in FIG. 35 - FIG. 36, the switch light guide plate 7 is provided with a LED switch hole 7-9 and a guide plate blocking hole 7-2 penetrating through its plate surface; the light-transmitting light guide plate 13 is provided with a LED light-transmitting hole 13-2 and a light-transmitting plate hole 13-3 penetrating through its plate surface, the light-transmitting light guide plate 13 is made of highly transparent materials (such as PC film, PMMA film, and glass film), and the upper and lower surfaces of the light-transmitting light guide plate 13 are also covered with the upper and lower reflective films (not shown in the figure); a light guide netted dot part is provided on the upper surface of the light-transmitting light guide plate 13, the light guide netted dot part is composed of light guide netted dots 13-1, and the light guide netted dots 13-1 are connected to the character optical path on the keycap 1 and make the characters transmit light; the blocking switch plate 9 is provided with a LED blocking hole 9-13 and a switch blocking body 9-14 penetrating through its plate surface; the flexible FPC circuit board 10 is provided with a side-lighted side LED10-6;
it should be ensured that the LED light-transmitting hole 13-2, the LED blocking hole 9-13, the LED switch hole 7-9, and the side LED10-6 are aligned, wherein the LED light-transmitting hole 13-2, the LED blocking hole 9-13, and the LED switch hole 7-9 can accommodate the side LED10-6;
it should be ensured that the switch blocking body 9-14 is aligned with the guide plate blocking hole 7-2, and the light-transmitting plate hole 13-3 can accommodate the switch blocking body 9-14;
it should be ensured that the LED switch hole 7-9 can accommodate a LED leakage blocking wall 9-12;
and it should be ensured that the LED switch hole 7-9 is connected to the optical path of the guide plate blocking hole 7-2.

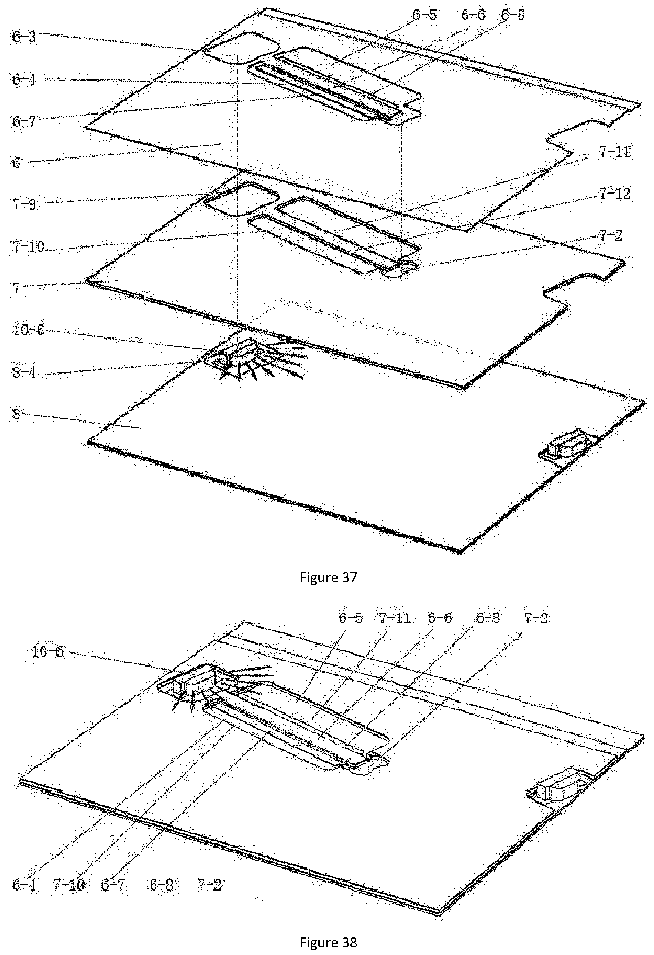

As shown in FIG. 37 - FIG. 38, the switch light guide plate 7 is provided with the light guide plate through holes penetrating through its plate surface, and the light guide plate through holes consist of a LED switch hole 7-9, a guide plate blocking hole 7-2, a left front optical path hole 7-10, and a right front optical path hole 7-11, wherein the optical transmitter is a side-lighted side LED10-6, the side LED10-6 is located in the LED switch hole 7-9, and the left front optical path hole 7-10 and the right front optical path hole 7-11 penetrate through the plate surface of the switch light guide plate 7 to form a front optical circuit board 7-12 between the left front optical path hole 7-10 and the right front optical path hole 7-11; one end of the front optical circuit board 7-12 is located on the side wall of the LED switch hole 7-9 and is connected to the optical path of the optical transmitter and the other end of the front optical circuit board 7-12 is located on the side wall of the guide plate blocking hole 7-2, and the front optical circuit board 7-12 is a part of the propagation optical path; the light transmitting window of the side LED10-6 is located at one end of the front optical circuit board 7-12, and the end is located on the side wall of the guide plate blocking hole 7-2.

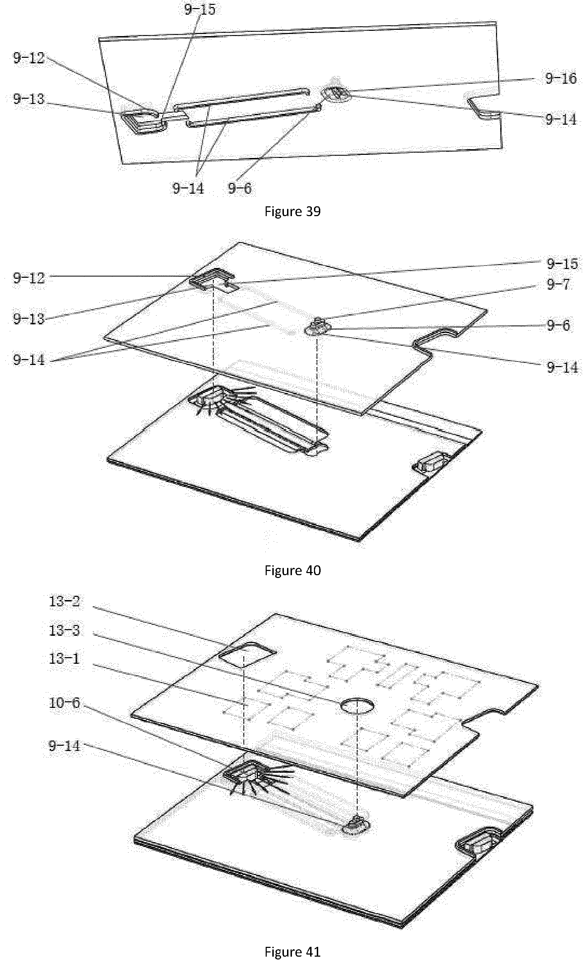

As shown in FIG. 39 - FIG. 40, the blocking switch plate 9 is provided with a LED blocking hole 9-13 penetrating through its plate surface, a light leakage blocking part is arranged on the LED blocking hole 9-13, the light leakage blocking part is composed of a LED leakage blocking wall 9-12 and a long strip leakage blocking wall 9-14 or the light leakage blocking part is composed of a LED leakage blocking wall 9-12, the LED leakage blocking wall 9-12 is located at the hole edges of the LED blocking hole 9-13, and the LED leakage blocking wall 9-12 is annular and protrudes from the surface of the blocking switch plate 9; the long strip leakage blocking wall 9-14 is arranged on the opposite side of the plate surface of the blocking switch plate 9 and the arched elastic switch blocking body 9-14 is also arranged on the blocking switch plate 9 (a blocking middle contact 9-7 is arranged on the top of the switch blocking body 9-14), and a light-transmitting gap 15 is arranged on the LED leakage blocking wall 9-12 between the LED blocking hole 9-13 and the switch blocking body 9-14.

As shown in FIG. 41 - FIG. 44, the metal support plate 2 is provided with a support plate middle hole 2-2, and the support plate middle hole 2-2 corresponds to the reset body 4; the blocking middle contact 9-7 passes through the support plate middle hole 2-2 and its upper end surface is located above the upper surface of the metal support plate 2.

The side-lighted LED is located in the LED switch hole 7-9 of the light guide plate 10-1, the LED switch hole 7-9 is connected to the blocking through hole 9-2 and the optical path of the optical receiver, and the light transmitting window of the LED corresponds to the light transmitting window of the optical receiver and is connected to the optical path; the blocking through hole 9-2 is connected to the optical path of the optical receiver.

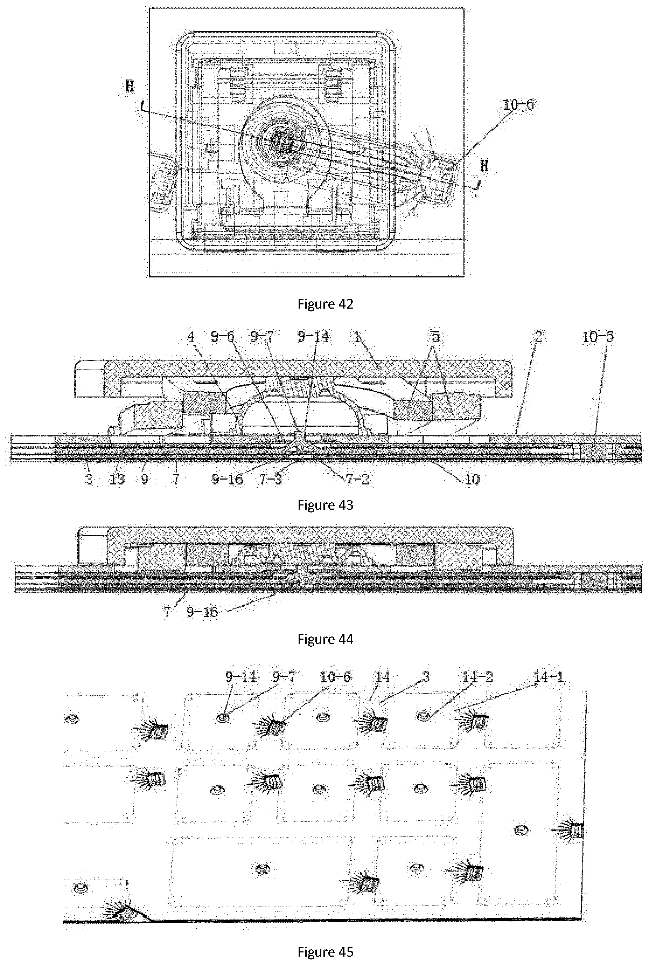

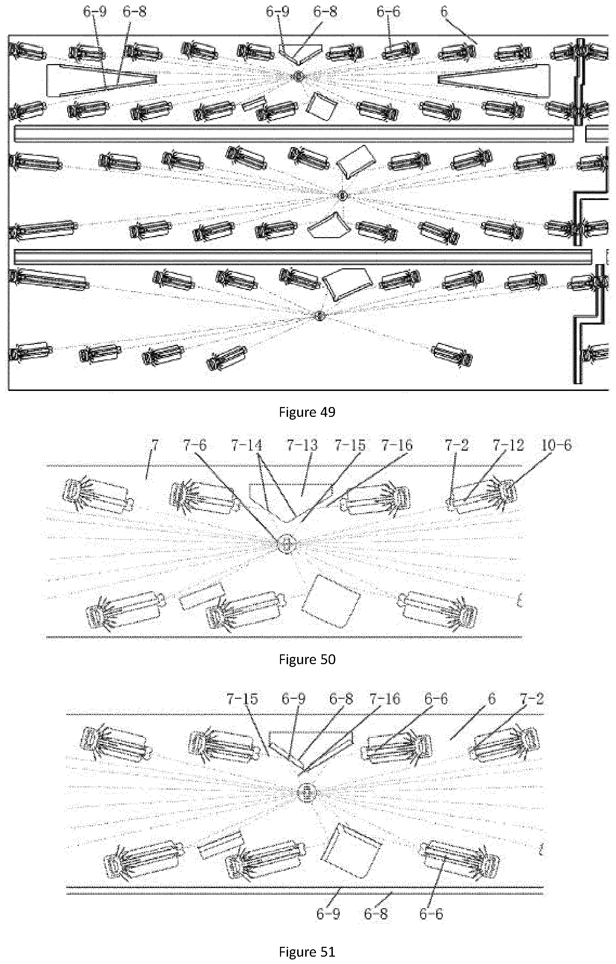

As shown in FIG. 45 - FIG. 51, the switch light guide plate 7 is divided into a plurality of optical zones, and the optical signals in the plurality of optical zones are separated from each other; in each optical zone, multiple optical transmitters are connected to the optical paths of a group of optical receivers respectively or to the optical path of an optical receiver;

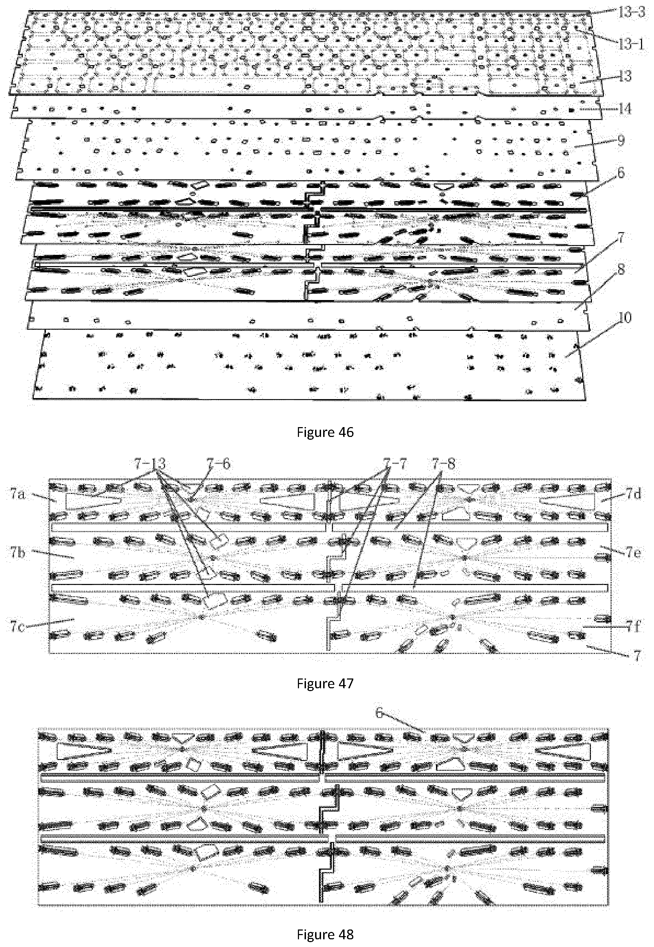

As shown in FIG. 46, the light guide plate consists of a light-transmitting light guide plate 13 and a switch light guide plate 7, and the light-transmitting light guide plate 13 is located above the switch light guide plate 7, wherein the light guide netted dots 13-1 are provided on the upper surface of the light-transmitting light guide plate 13, the optical signal transmitted by the optical transmitter is connected to the optical path of the light guide netted dots 13-1, and the light-transmitting light guide plate 13 is provided with a light-transmitting plate hole 13-3 penetrating through its plate surface; a blocking space 9-1 on the switch light guide plate 7 is aligned with the light-transmitting plate hole 13-3 on the light-transmitting light guide plate 13; the LED light-transmitting hole 13-2 provided on the light-transmitting light guide plate 13 is aligned with the LED switch hole 7-9 provided on the switch light guide plate 7, and the LED switch hole 7-9 and the LED light-transmitting hole 13-2 can accommodate the optical transmitter.

As shown in FIG. 46 - FIG. 51, the reflective films for reflecting optical signals are provided on the upper and lower surfaces of the switch light guide plate 7, and the reflective films are provided with the extension reflective films; the switch light guide plate 7 is provided with an opening reflective hole 7-13 penetrating through its plate surface, and the section formed by punching the formed opening reflective hole 7-13 is a guide plate end section 7-14, and the extension reflective films cover the guide plate end section 7-14 to form a light reflecting surface;

the included angle between the front guide optical path 7-15 and the guide plate end section 7-14 is equal to the included angle between the reflecting optical path 7-16 and the guide plate end section 7-14, so that the optical signal transmitted by the optical transmitter through the optical switch is transmitted via the guide plate end section 7-14 and the extension reflective films along the front guide optical path 7-15, the extension reflective films reflect the optical signal, and the reflected optical signal is connected to the optical receiver along the reflecting optical path 7-16.

The upper and lower surfaces of the switch light guide plate 7 are covered with reflective films, the reflective film on the upper surface of the switch light guide plate 7 is provided with an extension reflective film or the reflective film on the lower surface of the switch light guide plate 7 is provided with an extension reflective film, the extension reflective film or the extension reflective film corresponds to the guide plate end section 7-14, and the extension reflective film is bent to cover the guide plate end section 7-14 to be connected to the lower reflective film or the extension reflective film is bent to cover the guide plate end section 7-14 to be connected to the upper reflective film; the extension reflective film consists of a vertical reflective extension edge 6-9 and a horizontal reflective extension edge 6-10.

The rest is the same as Embodiment 1.

The above are only preferred embodiments of the present invention and are not intended to limit the present invention. Any modifications, equivalents, improvements made within the spirit and principles of the present invention shall fall within the scope of protection of the present invention.

## Claims

1. A light guide plate optical switch and light guide plate array optical switch module, comprising an optical transmitter, an optical receiver, a circuit board, an optical switch, a CPU, and a light guide plate, wherein the optical signal transmitted by the optical transmitter is connected to the optical path of the optical receiver through the optical switch, the propagation optical path between the optical transmitter and the optical receiver is on/off when the optical switch is triggered, and the CPU has an on/off interface and a detection interface;
wherein the light guide plate is divided into a plurality of optical zones, and the optical signals in the plurality of optical zones are separated from each other;
in each optical zone, multiple optical transmitters are connected to the optical paths of a group of optical receivers respectively or to the optical path of an optical receiver;
the optical transmitter is connected to the on/off interface, and the optical receiver is connected to the detection interface;
during use, the CPU continuously detects the signals of multiple detection interfaces;
when an optical switch in a certain optical zone is pressed, the CPU judges whether an optical switch in a certain optical zone is pressed by detecting the detection interface.

2. A light guide plate optical switch and light guide plate array optical switch module, comprising an optical transmitter, an optical receiver, a circuit board, an optical switch, and a light guide plate, wherein the optical signal transmitted by the optical transmitter is connected to the optical path of the optical receiver through the optical switch, and the propagation optical path between the optical transmitter and the optical receiver is on/off when the optical switch is triggered; wherein the light guide plate is divided into a plurality of optical zones, and the optical signals in the plurality of optical zones are separated from each other;
in each optical zone, multiple optical transmitters are connected to the optical paths of a group of optical receivers respectively or to the optical path of an optical receiver;
the optical transmitter is connected to a CPU output interface, the optical receiver is connected to a CPU input interface, and the optical transmitter in each optical zone transmits optical signals that can be recognized by the CPU;
during use, when an optical switch in a certain optical zone is pressed, the CPU judges whether an optical switch in a certain optical zone is pressed by detecting the CPU input interface.

3. The light guide plate optical switch and light guide plate array optical switch module according to claim 1 or 2, wherein the light guide plate consists of a switch light guide plate 7; the optical transmitter and the CPU output interface are connected as follows: an optical transmitter in one optical zone is connected to an optical transmitter in another optical zone to form an OT group...the above connection process is repeated to form a plurality of OT groups, and the plurality of OT groups are connected to a plurality of CPU output interfaces respectively.

4. A light guide plate optical switch and light guide plate array optical switch module, comprising an optical transmitter, an optical receiver, a circuit board, an optical switch, and a switch light guide plate, wherein the optical signal transmitted by the optical transmitter is connected to the optical path of the optical receiver through the optical switch, and the optical path between the optical transmitter and the optical receiver is on/off when the optical switch is triggered;
wherein the switch light guide plate 7 is divided into at least two optical zones, and the two optical zones are a 1 optical zone 7a and a 2 optical zone 7b, and the optical signal in the 1 optical zone 7a is separated from the optical signal in the 2 optical zone 7b;
the light transmitting windows of multiple optical transmitters in the 1 optical zone 7a are connected to multiple optical switches and the optical path of an optical receiver G1, and the light transmitting windows of multiple optical transmitters in the 2 optical zone 7b are connected to multiple optical switches and the optical path of an optical receiver G2;
one optical transmitter in the 1 optical zone 7a is connected to one optical transmitter in the 2 optical zone 7b to form a connected OT group, and a 1 OT group, a 2 OT group, a 3 OT group... a n OT group are connected to a 1CPU output interface, a 2CPU output interface, a 3CPU output interface... a nCPU output interface respectively;
the optical receiver G1 and the optical receiver G2 are connected to a 1CPU input interface and a 2CPU input interface of the CPU respectively;
during use, the CPU continuously detects the signals of the 1CPU input interface and the 2CPU input interface;
when an optical switch in the 1 optical zone 7a is pressed, the CPU determines the change of the optical signal in the 1 optical zone 7a by detecting the 1CPU input interface, and the CPU judges whether an optical switch in the 1 optical zone 7a is pressed based on the change of the optical signal;
when an optical switch in the 2 optical zone 7b is pressed, the CPU determines the change of the optical signal in the 2 optical zone 7b by detecting the 2CPU input interface, and the CPU judges whether an optical switch in the 2 optical zone 7b is pressed based on the change of the optical signal.

5. The light guide plate optical switch and light guide plate array optical switch module according to claim 3 or 4, wherein the light guide plate array optical switch module further comprises a CPU wherein the CPU has a plurality of output interfaces and a plurality of input interfaces, the connected OT group is connected to the output interface through the CPU output interface, and the optical receiver is connected to the input interface through the CPU input interface;
the CPU output interface and the CPU input interface are located on the same circuit board as the output interface and the input interface, or the CPU output interface and the CPU input interface are located on different circuit boards from the output interface and the input interface.

6. The light guide plate optical switch and light guide plate array optical switch module according to claim 5, wherein the CPU continuously scans and detects each CPU input interface circularly or continuously detects each CPU input interface simultaneously, and when the CPU detects the signal change of an output interface, the CPU judges whether an optical switch is triggered based on the optical zone where an OT group connected to the CPU output interface and the optical transmitter connected to the OT group are located.

7. The light guide plate optical switch and light guide plate array optical switch module according to claim 5, wherein when the array optical switch module works, the CPU is connected to a CPU output interface, and an OT group connected to the CPU output interface has at most only one optical transmitter in each optical zone to transmit the optical signals; one group of optical receivers in each optical zone receive the optical signals or one optical receiver receives the optical signals, each CPU input interface connected to the OT group has signal input, CPU judges whether an optical switch in each optical zone is triggered, and the CPU closes the CPU output interface;
the CPU is connected to another CPU output interface, and an OT group connected to the CPU output interface has at most only one optical transmitter in each optical zone to transmit the optical signals; one group of optical receivers in each optical zone receive the optical signals or one optical receiver receives the optical signals, each CPU input interface connected to the OT group has signal input, CPU judges whether an optical switch in each optical zone is triggered, and the CPU closes the CPU output interface;
the above process is repeated continuously;
when an optical switch is triggered, the optical path in the optical zone is blocked, so that the optical receiver in the optical zone cannot receive the optical signal, no signal input is available from the CPU input interface connected to the optical receiver, and the CPU judges the position of the optical switch based on the connected OT group and the corresponding relationship between the optical zone and the optical receiver.

8. The light guide plate optical switch and light guide plate array optical switch module according to claims 3 or 4 or 5 or 6 or 7, wherein the CPU output interfaces of the CPU transmit different feature signals, and the optical transmitters connected to the OT group transmit different feature signals in the same optical zone.

9. A light guide plate optical switch and light guide plate array optical switch module, comprising an optical transmitter, an optical receiver, a circuit board, an optical switch, and a light guide plate, wherein the optical signal transmitted by the optical transmitter is connected to the optical path of the optical receiver through the optical switch, and the optical path between the optical transmitter and the optical receiver is on/off when the optical switch is triggered;
wherein the light guide plate is divided into a plurality of optical zones, and the optical signals in the plurality of optical zones are separated from each other;
in each optical zone, multiple optical transmitters are connected to the optical paths of a group of optical receivers respectively or to the optical path of an optical receiver, and the optical receivers in each optical zone are connected to the signal input interfaces of the CPU respectively;
an optical transmitter in one optical zone is connected to an optical transmitter in another optical zone to form an OT group in which at most one optical transmitter in each optical zone is connected... the above connection process is repeated to form a plurality of OT groups;
the CPU has feature output interfaces transmitting multiple different feature signals, wherein each feature output interface is connected to a plurality of OT groups, the plurality of OT groups are connected to form an OT feature group, and each OT group forming the OT feature group transmits different feature signals;
multiple OT feature groups are connected to multiple optical input interfaces of the CPU respectively, and the on/off of each OT feature group is controlled by one optical input interface of the CPU;
during use, the CPU continuously detects the signals of the signal input interfaces.

10. A light guide plate optical switch and light guide plate array optical switch module, comprising an optical transmitter, an optical receiver, a circuit board, an optical switch, and a light guide plate, wherein the optical signal transmitted by the optical transmitter is connected to the optical path of the optical receiver through the optical switch, and the optical path between the optical transmitter and the optical receiver is on/off when the optical switch is triggered;
wherein the light guide plate is divided into n optical zones: a 1 optical zone 7a, a 2 optical zone 7b, a 3 optical zone 7c... n optical zone respectively, and the optical signals in the optical zones are separated from each other;
multiple optical transmitters in the 1 optical zone 7a are connected to the optical path of the optical receiver G1,
multiple optical transmitters in the 2 optical zone 7b are connected to the optical path of the optical receiver G2,
multiple optical transmitters in the 3 optical zone 7c are connected to the optical path of the optical receiver G3,...;
one optical transmitter in the 1 optical zone 7a, one optical transmitter in the 2 optical zone 7b, one optical transmitter in the 3 optical zone 7c... are electrically connected to form an OT group, and the above connection process is repeated to form a 1 OT group, a 2 OT group, a 3 OT group...;
the CPU has feature output interfaces transmitting multiple different feature signals, wherein each feature output interface is connected to a plurality of OT groups, the plurality of OT groups are connected to form a LED feature group, and the optical transmitters of the LED feature group in the same optical zone transmit different feature signals;
multiple LED feature groups are connected to multiple output interfaces of the CPU respectively,
the on/off of each LED feature group is controlled by one output interface of the CPU, and the output interface consists of an output interface B1, an output interface B2, an output interface B3...,
the 1LED feature group is connected to the output interface B1 of the CPU, and the output interface B1 controls the on/off of the 1LED feature group,
the 2LED feature group is connected to the output interface B2 of the CPU, and the output interface B2 controls the on/off of the 2LED feature group,
the 3LED feature group is connected to the output interface B3 of the CPU, and the output interface B3 controls the on/off of the 3LED feature group...,
the optical receiver G1 in the 1 optical zone 7a, the optical receiver G2 in the 2 optical zone 7b, the optical receiver G3 in the 3 optical zone 7c... are connected to the input interface C1 of the CPU, the input interface C2 of the CPU, the input interface C3, and the input interface C3 of the CPU... respectively;
during use, the CPU continuously detects the signals of the input interface C1, the input interface C2, the input interface C3...

11. The light guide plate optical switch and light guide plate array optical switch module according to claim 10, wherein the CPU has two feature output interfaces transmitting different feature signals: a feature output interface A1 and a feature output interface A2, and the feature output interface A1 is connected to a plurality of OT groups and the feature output interface A2 is connected to a plurality of OT groups;
two OT groups connected to the feature output interface A1 and the feature output interface A2 are connected to form a 1 OT feature group, and the 1 OT feature group is then connected to the output interface B1,
two OT groups connected to the feature output interface A1 and the feature output interface A2 are connected to form a 2 OT feature group, and the 2 OT feature group is then connected to the output interface B2,
two OT groups connected to the feature output interface A1 and the feature output interface A2 are connected to form a 3 OT feature group, and the 3 OT feature group is then connected to the output interface B3,...
two OT groups connected to the feature output interface A1 and the feature output interface A2 are connected to form a n OT feature group, and the n OT feature group is then connected to the output interface Bn;
the output interface B1, the output interface B2, the output interface B3..., and the output interface Bn control the on/off of the 1 OT feature group, the 2 OT feature group, the 3 OT feature group..., and the n OT feature group respectively.

12. The light guide plate optical switch and light guide plate array optical switch module according to claim 9 or 10 or 11, wherein the light guide plate array optical switch module further comprises a circuit board and the circuit board is provided with a CPU output interface, a CPU input interface, and a CPU feature output interface; the CPU output interface, the CPU input interface, and the CPU feature output interface are connected to the output interface of the CPU, the output interface of the CPU, and the feature output interface of the CPU respectively;
the CPU output interface, the CPU input interface, and the CPU feature output interface on one circuit board are connected to the output interface, the input interface, and the feature output interface on another circuit board respectively, or the CPU output interface, the CPU input interface, and the CPU feature output interface are correspondingly connected to the output interface, the input interface, and the feature output interface, and the CPU output interface, the CPU input interface, and the CPU feature output interface are located on the same circuit board as the output interface, the input interface, and the feature output interface.

13. The light guide plate optical switch and light guide plate array optical switch module according to claim 10 or 11 or 12, wherein the CPU has two feature output interfaces transmitting different feature signals: a feature output interface A1 and a feature output interface A2, wherein when the feature output interface A1 transmits 01 and the feature output interface A2 transmits 10, it should be ensured that two signals of 0 transmitted by the feature output interface A1 and 1 transmitted by the feature output interface A2 are synchronized in time and two signals of 1 transmitted by the feature output interface A1 and 0 transmitted by the feature output interface A2 are synchronized in time, to ensure that only one OT group can transmit light at every moment; or the CPU has three feature output interfaces transmitting different feature signals: a feature output interface A1, a feature output interface A2, and a feature output interface A3, wherein when the feature output interface A1 transmits 001, the feature output interface A2 transmits 100, and the feature output interface A3 transmits 010, it should be ensured that three signals of 0 transmitted by the feature output interface A1, 1 transmitted by the feature output interface A2, and 0 transmitted by the feature output interface A3 are synchronized in time, three signals of 0 transmitted by the feature output interface A1, 0 transmitted by the feature output interface A2, and 1 transmitted by the feature output interface A3 are synchronized in time, and three signals of 1 transmitted by the feature output interface A1, 0 transmitted by the feature output interface A2, and 0 transmitted by the feature output interface A3 are synchronized in time, to ensure that only one OT group can transmit light at every moment; or the CPU has four feature output interfaces transmitting different feature signals:...

14. The light guide plate optical switch and light guide plate array optical switch module according to claim 3 or 4 or 5 or 9 or 10, wherein when the number of optical transmitters in each optical zone is equal, the number of optical transmitters in each OT group is the same, or when the number of optical transmitters in each optical zone is not equal, the number of optical transmitters in some OT groups is different.

15. A light guide plate optical switch and light guide plate array optical switch module, comprising an optical transmitter, an optical receiver, a circuit board, a light guide plate, and an optical switch, wherein the optical signal transmitted by the optical transmitter is connected to the optical path of the optical receiver through the propagation optical path on the light guide plate and the optical switch, and the optical path between the optical transmitter and the optical receiver is on/off when the optical switch is triggered;
wherein the light guide plate consists of a switch light guide plate 7, and the switch light guide plate 7 is provided with the light guide plate through holes penetrating through its plate surface; the light guide plate through holes consist of a LED switch hole 7-9, a guide plate blocking hole 7-2, a left front optical path hole 7-10, and a right front optical path hole 7-11, wherein the optical transmitter is a side-lighted optical transmitter, the optical transmitter is located in the LED switch hole 7-9, and the left front optical path hole 7-10 and the right front optical path hole 7-11 penetrate through the plate surface of the switch light guide plate 7 to form a front optical circuit board 7-12 between the left front optical path hole 7-10 and the right front optical path hole 7-11; one end of the front optical circuit board 7-12 is located on the side wall of the LED switch hole 7-9 and is connected to the optical path of the optical transmitter and the other end of the front optical circuit board 7-12 is located on the side wall of the guide plate blocking hole 7-2, and the front optical circuit board 7-12 is a part of the propagation optical path.

16. The light guide plate optical switch and light guide plate array optical switch module according to claim 15, wherein the upper and lower surfaces of the switch light guide plate 7 are covered with a reflective film respectively wherein one reflective film is provided with a right front reflective hole 6-5 and a left front reflective hole 6-4 penetrating through the plate surface of the switch light guide plate 7, and the right front reflective hole 6-5 and the left front reflective hole 6-4 correspond to the right front optical path hole 7-11 and the left front optical path hole 7-10 respectively;
the reflective film is provided with an outward extending right front extension film 6-8 and a left front extension film 6-7 at the edges of the right front reflective hole 6-5 and the left front reflective hole 6-4 near the front optical circuit board 7-12 respectively; the right front extension film 6-8 and the left front extension film 6-7 form an extension reflective film of the reflective film, and the extension reflective film of the reflective film is bonded with the other reflective film;
the left and right sections of the front optical circuit board 7-12 are covered by the left front extension film 6-7 and the right front extension film 6-8 respectively, and the left and right sections of the front optical circuit board 7-12 are formed by the formed right front reflective hole 6-5 and the left front reflective hole 6-4.

17. The light guide plate optical switch and light guide plate array optical switch module according to claim 15, wherein the switch light guide plate 7 is divided into a plurality of optical zones, and the optical signals in the plurality of optical zones are separated from each other; in each optical zone, multiple optical transmitters are connected to the optical paths of a group of optical receivers respectively or to the optical path of an optical receiver.

18. The light guide plate optical switch and light guide plate array optical switch module according to claim 17, wherein the optical switch module further comprises reflective films for reflecting optical signals, the reflective films for reflecting optical signals are provided on the upper and lower surfaces of the switch light guide plate 7, and the reflective films are provided with the extension reflective films;
the switch light guide plate 7 is provided with an opening reflective hole 7-13 penetrating through its plate surface, and the section formed by punching the formed opening reflective hole 7-13 is a guide plate end section 7-14, and the extension reflective films cover the guide plate end section 7-14 to form a light reflecting surface;
the included angle between the front guide optical path 7-15 and the guide plate end section 7-14 is equal to the included angle between the reflecting optical path 7-16 and the guide plate end section 7-14, so that the optical signal transmitted by the optical transmitter through the optical switch is transmitted via the guide plate end section 7-14 and the extension reflective films along the front guide optical path 7-15, the extension reflective films reflect the optical signal, and the reflected optical signal is connected to the optical receiver along the reflecting optical path 7-16.

19. The light guide plate optical switch and light guide plate array optical switch module according to claim 15, wherein the light guide plate consists of a light-transmitting light guide plate 13 and a switch light guide plate 7, and the light-transmitting light guide plate 13 is located above the switch light guide plate 7 wherein the light guide netted dots 13-1 are provided on the upper surface of the light-transmitting light guide plate 13, the optical signal transmitted by the optical transmitter is connected to the optical path of the light guide netted dots 13-1, and the light-transmitting light guide plate 13 is provided with a light-transmitting plate hole 13-3 penetrating through its plate surface; a blocking space (9-1) on the switch light guide plate 7 is aligned with the light-transmitting plate hole 13-3 on the light-transmitting light guide plate 13; the LED light-transmitting hole 13-2 provided on the light-transmitting light guide plate 13 is aligned with the LED switch hole 7-9 provided on the switch light guide plate 7, and the LED switch hole 7-9 and the LED light-transmitting hole 13-2 can accommodate the optical transmitter.

20. The light guide plate optical switch and light guide plate array optical switch module according to claim 15, wherein the optical switch module further comprises a light leakage blocking part, and the light leakage blocking part blocks the optical signal from leaking out of the optical switch.
